(19) Europäisches Patentamt
European Patent Office
Office européen des brevets

(11) EP 4 336 424 A1

(12) **EUROPEAN PATENT APPLICATION**
published in accordance with Art. 153(4) EPC

(43) Date of publication:
**13.03.2024 Bulletin 2024/11**

(21) Application number: **22823993.5**

(22) Date of filing: **19.05.2022**

(51) International Patent Classification (IPC):
***G06Q 10/04*** *(2023.01)*

(52) Cooperative Patent Classification (CPC):
**G06Q 10/04; G06Q 10/06; G06Q 50/04**

(86) International application number:
**PCT/CN2022/093732**

(87) International publication number:
**WO 2022/262511 (22.12.2022 Gazette 2022/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.06.2021 CN 202110680969**

(71) Applicant: **Huawei Technologies Co., Ltd.**
**Shenzhen, Guangdong 518129 (CN)**

(72) Inventors:
- **LI, Xijun**
  **Shenzhen, Guangdong 518129 (CN)**
- **HAO, Xiaotian**
  **Shenzhen, Guangdong 518129 (CN)**
- **YUAN, Mingxuan**
  **Shenzhen, Guangdong 518129 (CN)**
- **HAO, Jianye**
  **Shenzhen, Guangdong 518129 (CN)**
- **ZENG, Jia**
  **Shenzhen, Guangdong 518129 (CN)**

(74) Representative: **Gill Jennings & Every LLP**
**The Broadgate Tower**
**20 Primrose Street**
**London EC2A 2ES (GB)**

# (54) SERVICE DATA PROCESSING METHOD AND DEVICE

(57) This application provides a service data processing method and apparatus, to solve a large-scale linear programming problem and quickly program a large-scale service. The method includes: obtaining a target function and a constraint condition, where the constraint condition includes a constraint relationship between a plurality of variables, and the target function includes at least one variable of the plurality of variables; selecting an initial variable from the plurality of variables for a base variable group; sorting optimized values of variables in a non-base variable group to obtain a maximum heap structure, where each node in the maximum heap structure stores an identifier of a variable and an optimized value corresponding to the variable; updating the non-base variable group and the base variable group based on a first target variable, where the first target variable is a variable corresponding to an identifier stored by a second node in the maximum heap structure, and the second node meets a first condition; and obtaining a solving target of a service problem based on a variable in an updated base variable group and the constraint condition.

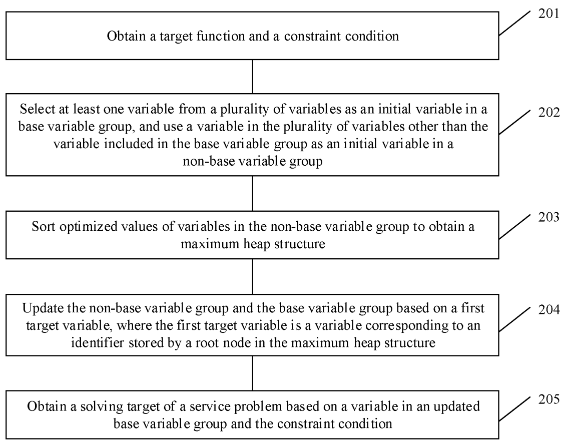


FIG. 2

EP 4 336 424 A1

## Description

This application claims priority to Chinese Patent Application No. 202110680969.8, filed with the China National Intellectual Property Administration on June 18, 2021 and entitled "SERVICE DATA PROCESSING METHOD AND APPARATUS", which is incorporated herein by reference in its entirety.

## TECHNICAL FIELD

This application relates to the service programming field, and in particular, to a service data processing method and apparatus.

## BACKGROUND

A programming problem is a process of modeling a complex real problem and performing solving, and is widely used in the industry. A programming model can be used in warehouse transfer, supply and demand simulation, multi-factory production scheduling, vehicle scheduling, and the like to obtain an optimal solution, and an appropriate solution is selected to meet service requirements.

As the complexity and scale of actual service scenarios increase sharply, service programming problems in some industries become very large and complex. Therefore, how to quickly program a large-scale service becomes an urgent problem to be resolved.

## SUMMARY

This application provides a service data processing method and apparatus, to quickly program a large-scale service.

According to a first aspect, an embodiment of this application provides a service data processing method, including: A service data processing apparatus obtains a target function and a constraint condition, where the target function indicates a solving target of a service problem, the service problem may be a problem like factory production scheduling, warehouse transfer, vehicle scheduling, network traffic scheduling, and the like, the constraint condition indicates a restriction condition of the service problem, the constraint condition includes a constraint relationship between a plurality of variables, and the target function includes at least one variable of the plurality of variables. Then, the service data processing apparatus selects the at least one variable from the plurality of variables as an initial variable in a base variable group, and uses a variable in the plurality of variables other than the variable included in the base variable group as an initial variable in a non-base variable group, where the plurality of variables include a decision variable and a sparse variable, and the variable in the base variable group is used to obtain a final solving target. Therefore, a quantity of variables included in the base variable group is determined based on a quantity of decision variables, or a quantity of variables included in the base variable group is determined based on a quantity of constraint conditions. If the quantity of decision variables is inconsistent with the quantity of constraint conditions, the quantity of variables included in the base variable group may be determined based on a smaller value of the two. It should be noted that any manner of determining a quantity of variables included in a base variable group in the conventional technology may be used in embodiments of this application. A manner of determining a quantity of variables included in a base variable group is not limited in embodiments of this application. Then, the service data processing apparatus sorts optimized values of variables in the non-base variable group, to obtain a maximum heap structure, where a first node in the maximum heap structure stores an identifier of a first variable and an optimized value of the first variable, the first node is any node in the maximum heap structure, the first variable is any variable in the non-base variable group, and the optimized value of the first variable indicates an optimization rate of the target function when a value of the first variable changes. If a value of each variable in the target function changes, a value of the target function changes. When a value of each variable changes to a same degree (for example, each variable is incremented by 1), changing a value of a variable can enable the value of the target function closest to the solving target, that is, a higher optimization rate of the target function indicates a larger optimized value of the variable. It should be noted that a manner of obtaining an optimized value of the variable in the conventional technology may be used in embodiments of this application. A manner of obtaining an optimized value of a variable is not limited in embodiments of this application. The service data processing apparatus updates the non-base variable group and the base variable group based on a first target variable, where the first target variable is a variable corresponding to an identifier stored by a second node in the maximum heap structure, and the second node meets a first condition. The service data processing apparatus obtains the solving target of the service problem based on a variable in an updated base variable group and the constraint condition. A process of obtaining the solving target of the target function includes a process of repeatedly selecting a new base variable. In a process of selecting a new base variable, a for loop statement generally needs to be invoked for a plurality of times, to execute a comparison algorithm. This obtains the base variable that can optimize the value of the target function fastest. This process is time-consuming. However, in this embodiment of this application, a stack structure is introduced, to store the optimized values of the variables, and a maximum heap algorithm is invoked to sort the optimized values of variables, to obtain the maximum heap structure. This can directly obtain the new base variable based on the maximum heap structure, accelerate a calculation process of selecting the base variable, improve problem solving efficiency, and accelerate a speed of programming a large-scale service.

In a possible implementation of the first aspect, the first condition includes that the second node is a root node in the maximum heap structure. In this implementation, in the process of selecting the new base variable, the new base variable only needs to be obtained based on a variable corresponding to an identifier stored in the root node in the maximum heap structure. This accelerates the calculation process of selecting the base variable, improves problem solving efficiency, and accelerates the speed of programming the large-scale service.

In a possible implementation of the first aspect, the first condition includes that the second node is a root node in the maximum heap structure when a first difference is greater than a first threshold, the first difference is a difference value between a largest optimized value and a $K^{th}$ largest optimized value in the maximum heap structure, and K is a positive integer greater than 1. In this implementation, the difference between first K largest optimized values in the maximum heap structure is measured based on the difference value. If there is a huge difference between the first K largest optimized values, in this case, the service data processing apparatus can accurately distinguish the K optimized values, and accurately sort the K optimized values. In this case, the new base variable is obtained based on a variable corresponding to an identifier stored in the root node in the maximum heap structure. This ensures accuracy while accelerating the calculation process of selecting the base variable, improves problem solving efficiency, and accelerates the speed of programming the large-scale service.

In a possible implementation of the first aspect, the first condition includes that, when a first difference is less than or equal to a first threshold, the second node is a node that stores a target identifier in the maximum heap structure, and an optimized value of a variable corresponding to the target identifier is one of first K largest optimized values in the maximum heap structure. In this implementation, if there is a small difference between the first K largest optimized values, due to a problem like a loss of precision of a floating-point number operation, the service data processing apparatus cannot accurately distinguish the K optimized values and cannot accurately sort the K optimized values. To avoid degeneracy in a solving process, a node corresponding to the target identifier is output.

In a possible implementation of the first aspect, the target identifier is an identifier in K identifiers that is stored by a root node in the maximum heap structure for a smallest quantity of times, and optimized values of variables corresponding to the K identifiers are the first K largest optimized values in the maximum heap structure. In this implementation, the variable corresponding to the identifier that is stored by the root node in the maximum heap structure for the smallest quantity of times is selected to update the base variable group. This can prevent the variable from being replaced again to some extent, and ensure that a variable in a final base variable group is an optimal variable for solving the target function. When degeneracy occurs, a reasonable non-base variable can still be obtained and added to the base variable group, to perform last update on the base variable group and the non-base variable.

In a possible implementation of the first aspect, the updating the non-base variable group and the base variable group based on a first target variable includes: exchanging the first target variable with a second target variable in the base variable group. After the exchange, the base variable group includes the first target variable and no longer includes the second target variable; and the non-base variable group includes the second target variable and no longer includes the first target variable. There are a plurality of solutions for selecting the second target variable. This is not limited in this application. In this implementation, a specific manner of updating the base variable group and the non-base variable group is provided. The new base variable needs to be obtained only based on the variable corresponding to the identifier stored by the second node in the maximum heap structure. This accelerates the calculation process of selecting the base variable.

In a possible implementation of the first aspect, the method further includes: updating the maximum heap structure based on the second target variable. In one implementation provided in this application, the maximum heap structure does not need to be totally updated, and only data stored by one node in the maximum heap structure needs to be updated. This further improves a solving speed. For example, only an optimized value of the first target variable whose optimized value changes most in the maximum heap structure is updated, or an optimized value of the first target variable and an optimized value of the second target variable are updated, or certainly, an optimized value of each variable in the maximum heap structure is updated.

In a possible implementation of the first aspect, the method further includes: iteratively updating the base variable group, the non-base variable group, and the maximum heap structure for a plurality of times until a stop condition is met. Generally, if the base variable group is updated only once, the solving target usually cannot be obtained. The base variable group, the non-base variable group, and the maximum heap structure need to be iteratively updated for a plurality of times until the solving target is obtained.

In a possible implementation of the first aspect, the stop condition includes that an optimized value stored by the root node in the maximum heap structure is less than a second threshold. When the optimized value stored by the root node is less than a threshold, for example, 0, it indicates that a benefit that may be brought by updating the base variable group and the non-base variable group is already very small, and the update may be stopped. This avoids a waste of computing resources and time.

In a possible implementation of the first aspect, the stop condition includes that a quantity of iterative updates reaches a third threshold. Whether to continue the update is determined based on the possible benefit of the update, and further the update may be stopped when the quantity of updates reaches a specified quantity of times. Therefore, a user can balance solving time and precision as required.

According to a second aspect, an embodiment of this application provides a production plan generation method, including: obtaining a target function and a constraint condition, where the target function indicates a solving target of a product production plan, the constraint condition indicates a restriction condition of the production plan, the constraint condition includes a constraint relationship between a plurality of variables related to production, and the target function includes at least one variable of the plurality of variables. For example, the solving target may include minimizing production costs, minimizing inventory costs, minimizing transportation costs, and the like. The restriction condition may include constraints such as a factory production capacity upper limit, an item processing structure, a processing time limit, material costs, and a supply chain condition. The variable may include a decision variable, like deciding production volumes of different products per day, and production quotas of different factories, and may also include a sparse variable, like a variable introduced to construct a linear programming standard type. The method further includes: selecting the at least one variable from the plurality of variables as an initial variable in a base variable group, and using a variable in the plurality of variables other than the variable included in the base variable group as an initial variable in a non-base variable group; sorting optimized values of variables in the non-base variable group, to obtain a maximum heap structure, where a first node in the maximum heap structure stores an identifier of a first variable and an optimized value of the first variable, the first node is any node in the maximum heap structure, the first variable is any variable in the non-base variable group, the optimized value of the first variable indicates an optimization rate of the target function when a value of the first variable changes, and the optimization rate of the target function indicates a reduction rate of generation plan costs; updating the non-base variable group and the base variable group based on a first target variable, where the first target variable is a variable corresponding to an identifier stored by a second node in the maximum heap structure, and the second node meets a first condition; and obtaining the production plan based on a variable in an updated base variable group and the constraint condition. It can be learned from the second aspect that, a stack structure is introduced, to store the optimized values of the variables, and a maximum heap algorithm is invoked to sort the optimized values of the variables, to obtain the maximum heap structure. This can directly obtain a new base variable based on the maximum heap structure, obtain the production plan based on the variable in the updated base variable group and the constraint condition, and can accelerate a rate of obtaining the generation plan.

In a possible implementation of the second aspect, the first condition includes that the second node is a root node in the maximum heap structure. In this implementation, in a process of selecting the new base variable, the new base variable only needs to be obtained based on a variable corresponding to an identifier stored in the root node in the maximum heap structure. This accelerates a calculation process of selecting the base variable, improves problem solving efficiency, and accelerates a speed of obtaining the generation plan.

In a possible implementation of the second aspect, the first condition specifically includes that the second node is a root node in the maximum heap structure when a first difference is greater than a first threshold, the first difference is a difference value between a largest optimized value in the maximum heap structure and a $K^{th}$ largest optimized value in the maximum heap structure, and K is a positive integer greater than 1. In this implementation, the difference between first K largest optimized values in the maximum heap structure is measured based on the difference value. If there is a huge difference between the first K largest optimized values, in this case, a service data processing apparatus can accurately distinguish the K optimized values, and accurately sort the K optimized values. In this case, the new base variable is obtained based on a variable corresponding to an identifier stored in the root node in the maximum heap structure. This ensures accuracy while accelerating the calculation process of selecting the base variable, improves problem solving efficiency, and accelerates a speed of obtaining the generation plan.

In a possible implementation of the second aspect, the first condition further includes that, when a first difference is less than or equal to a first threshold, the second node is a node that stores a target identifier in the maximum heap structure, and an optimized value of a variable corresponding to the target identifier is one of first K largest optimized values in the maximum heap structure. In this implementation, if there is a small difference between the first K largest optimized values, due to a problem like a loss of precision of a floating-point number operation, a service data processing apparatus cannot accurately distinguish the K optimized values and cannot accurately sort the K optimized values. To avoid degeneracy in a solving process, a node corresponding to the target identifier is output.

In a possible implementation of the second aspect, the target identifier is an identifier in K identifiers that is stored by a root node in the maximum heap structure for a smallest quantity of times, and optimized values of variables corresponding to the K identifiers are the first K largest optimized values in the maximum heap structure. In this implementation, the variable corresponding to the identifier that is stored by the root node in the maximum heap structure for the smallest quantity of times is selected to update the base variable group. This can prevent the variable from being replaced again to some extent, and ensure that a variable in a final base variable group is an optimal variable for solving the target function. When degeneracy occurs, a reasonable non-base variable can still be obtained and added to the base variable group, to perform last update on the base variable group and the non-base variable.

In a possible implementation of the second aspect, the updating the non-base variable group and the base variable group based on a first target variable includes: exchanging the first target variable with a second target variable in the base variable group. After the exchange, the base variable group includes the first target variable and no longer includes the second target variable; and the non-base variable group includes the second target variable and no longer includes the first target variable. There are a plurality of solutions for selecting the second target variable. This is not limited in this application. In this implementation, a specific manner of updating the base variable group and the non-base variable group is provided. The new base variable needs to be obtained only based on the variable corresponding to the identifier stored by the second node in the maximum heap structure. This accelerates the calculation process of selecting the base variable.

In a possible implementation of the second aspect, the method further includes: updating the maximum heap structure based on the second target variable. In one implementation provided in this application, the maximum heap structure does not need to be totally updated, and only data stored by one node in the maximum heap structure needs to be updated. This further improves a solving speed. For example, only an optimized value of the first target variable whose optimized value changes most in the maximum heap structure is updated, or an optimized value of the first target variable and an optimized value of the second target variable are updated, or certainly, an optimized value of each variable in the maximum heap structure is updated.

In a possible implementation of the second aspect, the method further includes: iteratively updating the base variable group, the non-base variable group, and the maximum heap structure for a plurality of times until a stop condition is met. Generally, if the base variable group is updated only once, the solving target usually cannot be obtained. The base variable group, the non-base variable group, and the maximum heap structure need to be iteratively updated for a plurality of times until the solving target is obtained.

In a possible implementation of the second aspect, the stop condition includes that an optimized value stored by the root node in the maximum heap structure is less than a second threshold. When the optimized value stored by the root node is less than a threshold, for example, 0, it indicates that benefit that may be brought by updating the base variable group and the non-base variable group is already very small, and the update may be stopped. This avoids a waste of computing resources and time.

In a possible implementation of the first aspect, the stop condition includes that a quantity of iterative updates reaches a third threshold. Whether to continue the update is determined based on the possible benefit of the update, and further the update may be stopped when the quantity of updates reaches a specified quantity of times. Therefore, a user can balance solving time and precision as required.

In a possible implementation of the second aspect, the stop condition includes that a quantity of iterative updates reaches a third threshold.

According to a third aspect, an embodiment of this application provides a service data processing apparatus. The service data processing apparatus has a function of implementing the data processing method according to the first aspect. The function may be implemented by hardware, or may be implemented by hardware executing corresponding software. The hardware or the software includes one or more modules corresponding to the function.

According to a fourth aspect, an embodiment of this application provides a production plan generation apparatus. The production plan generation apparatus has a function of implementing the production plan generation method according to the second aspect. The function may be implemented by hardware, or may be implemented by hardware executing corresponding software. The hardware or the software includes one or more modules corresponding to the function.

According to a fifth aspect, an embodiment of this application provides a service data processing apparatus, including a processor and a memory. The processor and the memory are interconnected through a line, and the processor invokes program code in the memory to perform a processing-related function in the data processing method shown in any implementation of the first aspect. Optionally, the data processing apparatus may be a chip.

According to a sixth aspect, an embodiment of this application provides a production plan generation apparatus, including a processor and a memory. The processor and the memory are interconnected through a line, and the processor invokes program code in the memory to perform a processing-related function in the first method shown in any implementation of the second aspect. Optionally, the production plan generation apparatus may be a chip.

According to a seventh aspect, an embodiment of this application provides a digital processing chip or a chip. The chip includes a processing unit and a communication interface. The processing unit obtains program instructions through the communication interface, the program instructions are executed by the processing unit, and the processing unit is configured to perform a processing-related function according to any optional implementation of the first aspect or the second aspect.

According to an eighth aspect, an embodiment of this application provides a computer-readable storage medium including instructions. When the instructions are run on a computer, the computer is enabled to perform the method according to any optional implementation of the first aspect or the second aspect.

According to a ninth aspect, an embodiment of this application provides a computer program product including a program/instructions. When the computer program product is executed by a processor, the processor is enabled to perform the method according to any optional implementation of the first aspect or the second aspect.

## BRIEF DESCRIPTION OF DRAWINGS

FIG. 1 is a schematic diagram of a system architecture according to this application;
FIG. 2 is a schematic flowchart of a service data processing method according to this application;
FIG. 3 is a schematic diagram of a maximum heap structure according to this application;
FIG. 4 is a schematic diagram of progressively updating a maximum heap structure according to this application;
FIG. 5 is another schematic diagram of progressively updating a maximum heap structure according to this application;
FIG. 6 is a schematic flowchart of another service data processing method according to this application;
FIG. 7 is a schematic flowchart of a production plan generation method according to this application;
FIG. 8 is a schematic flowchart of still another service data processing method according to this application;
FIG. 9 is a schematic diagram of an application scenario of a programming problem according to this application;
FIG. 10 is a schematic diagram of solution effect of a service data processing method according to this application;
FIG. 11 is a schematic diagram of solution effect of a service data processing method according to this application;
FIG. 12 is a schematic diagram of a structure of a service data processing apparatus according to this application;
FIG. 13 is a schematic diagram of a structure of a production plan generation apparatus according to this application;
FIG. 14 is a schematic diagram of a structure of another service data processing apparatus according to this application; and
FIG. 15 is a schematic diagram of a structure of another production plan generation apparatus according to this application.

## DESCRIPTION OF EMBODIMENTS

The following describes technical solutions in embodiments of this application with reference to accompanying drawings in embodiments of this application. It is clear that the described embodiments are merely a part rather than all of embodiments of this application. All other embodiments obtained by a person of ordinary skill in the art based on embodiments of this application without creative efforts shall fall within the protection scope of this application.

An optimization problem (optimization problem) indicates selecting a group of parameters (variables) in an industrial design, to enable, under a series of related restriction conditions (constraint conditions), a design objective (target function) to reach an optimal value. Linear programming is an important field in the optimization problem. Linear programming (linear programming) is an optimization problem in which the target function and the constraint condition are in a linear relationship. Many practical problems in various fields can be solved by linear programming. For example, warehouse transfer, supply and demand simulation, multi-factory production scheduling, airport scheduling, vehicle scheduling, student course scheduling, nurse scheduling, and the like are all solving problems in linear programming problems. Embodiments of this application are applied to any scenario of solving a linear programming problem. To better understand this solution, an application scenario of this solution is described by using a multi-factory production scheduling problem as an example. For example, a customer requirement is to manufacture 2000 personal computers (personal computers, PCs), 1000 hosts, and 800 laptop computers within three days, where one host needs to be configured for one PC in a material assembly relationship. There are two factories: a factory A and a factory B. The factory A can process a PC and a host, and the factory B can process a host and a laptop computer. The factory A can process a maximum of 1000 PCs or hosts each day, and the factory B can process a maximum of 1000 hosts or laptop computers each day. In this case, constraint conditions and a target function need to be generated based on the customer's order requirements, existing raw materials of manufacturing enterprises, a production capacity of the factory A, a production capacity of the factory B, and the material assembly relationship to obtain a production scheduling plan for minimizing processing costs, minimizing processing time, and maximizing an order fulfillment rate (that is, delivering the customer requirement on time and quantity). It should be understood that the foregoing example is merely used to facilitate understanding of the application scenario of this application, and is not intended to limit this solution.

Simplex algorithm (simplex algorithm) is one of the most commonly used and effective algorithms for solving a linear programming problem. An idea of solving the linear programming problem by using the simplex algorithm is as follows: Determine an initial basic feasible solution, that is, determine, from a vertex in a feasible domain, whether the vertex is an optimal solution; and if the vertex is the optimal solution, the problem is solved; otherwise, find a new basic feasible solution, that is, switch to another vertex (the conversion is to optimize a value of a target function), and then determine whether the vertex is the optimal solution. This process repeats until the value of the target function is optimal. Therefore, the basic feasible solution that makes the value of the target function optimal is the optimal solution of the problem. The following describes a concept of the feasible domain and a concept of the basic feasible solution. In the linear programming problem, an inequality constraint condition $g(x)\leq 0$ may divide design space into two parts: one part meets a constraint condition $g(x)<0$, and the other part does not meet a constraint condition $g(x)>0$. A sub-interface of the two parts is referred to as a constraint surface, that is, $g(x)=0$. If a design has m inequality constraint conditions, m constraint surfaces form two regions in the design space. A variable selection region that meets an inequality constraint equation set is referred to as a design feasible domain, or a constraint region, or a feasible domain. A design variable selection region that does not meet any constraint condition of the inequality constraint equation set is referred to as a design non-feasible domain or a constraint violation region. Solutions corresponding to design points in the feasible domain are all feasible solutions. Currently, mature theories have proved that in the optimization problem, the optimal solution is a boundary point in the feasible domain, and the basic feasible solution is the boundary point in the feasible domain.

The applicant finds that there are at least the following two disadvantages in solving the linear programming problem by using the simplex algorithm:

1. Slow solving speed

When the linear programming problem is solved by using the simplex algorithm, every time a new basic feasible solution is searched for, the basic feasible solution that can make the value of the target function reach an optimal value more quickly needs to be searched for from a large quantity of basic feasible solutions. If the linear programming problem relates to a large quantity of variables, the process takes longer time, and the solving speed becomes slower.

For example, it is assumed that a target function includes a plurality of variables, and a value change of each variable may cause a value change of the target function. It is equivalent to that the target function has a plurality of optimization directions. How to quickly obtain, from the plurality of optimization directions, a quantity (a value of each variable) that should be optimized in each direction, to make the value of the target function optimal (obtain a solving target). This relates to a huge calculation amount. Specifically, a group of variables may be first selected from the plurality of variables as initial base variables. Other variables that are not the initial base variables are used as non-initial base variables. Values of the non-initial basic variables are 0, and values of the initial basic variables may be obtained based on the values of the non-initial basic variables and a constraint condition. The values of this group of initial base variables and the values of non-base variables form an initial basic feasible solution. An initial value of the target function may be obtained based on the initial basic feasible solution. A process of selecting a new base variable is repeatedly executed, and a value of the target function may be obtained based on a base variable selected each time. The simplex algorithm is used to make a value of the target function obtained each time closer to a solving target than a value of the target function obtained last time. When no new group of base variables can be found to optimize the value of the target function, a finally selected base variable is a final base variable, and an optimal solution of the target function, namely, an optimal solution of a linear programming problem, may be obtained based on the finally selected base variable.

In each process of selecting the new base variable, the selected group of base variables needs to be enabled to optimize the value of the target function as quickly as possible. This relates to a large quantity of comparison and calculation processes, and is time-consuming. To better understand that the value of the target function is optimized as quickly as possible, description is provided herein with reference to an example. It is assumed that in a current process of selecting a new base variable, N groups of base variables are used as candidate base variable groups. It is assumed that the N groups of base variables include a group A of base variables and a group B of base variables, and it is assumed that the group A of base variables makes a value of a target function increase by 10 than a value of the target function corresponding to an initial basic feasible solution. The group B of variables makes a value of the target function increase by 20 than the value of the target function corresponding to the initial basic feasible solution. Therefore, it is considered that the group B of variables can optimize the value of the target function faster than the group A of variables. If the N groups of base variables are used as the candidate base variable groups, speeds at which the N groups of base variables can optimize the value of the target function need to be compared, to select a group of base variables that can optimize the value of the target function fastest. It is apparent that, a larger quantity of variables indicates larger N and a larger calculation amount in the comparison process.

2. Degeneracy (degeneracy) in a solving process

In the process of continuously selecting new base variables, theoretically, the value of the target function is closer to the optimal solution. However, the applicant finds that, degeneracy may occur in the process of continuously selecting the new base variables. That is, in the process of continuously selecting the new base variables, the value of the target function is not continuously optimized, or a problem that the optimal solution cannot be output occurs.

In embodiments of this application, it is found that degeneracy occurs because computer calculation precision is insufficient. At a later phase of target function optimization, values of most variables may be close to the optimal solution, and only values of several variables need to be further optimized. However, changes of the values of the several variables may not greatly affect an optimization degree of the target function, and a computer may not be able to obtain how to optimize the variables to obtain the optimal solution. Further, for example, it is assumed that after the process of selecting the new base variable is performed for multiple times, currently three groups of base variables are used as candidate base variable groups. It is assumed that a first group of base variables makes a value of the target function increase by 5.111111112 than a value of the target function corresponding to a base variable selected last time. A second group of base variables makes a value of the target function increase by 5.111111113 than the value of the target function corresponding to the base variable selected last time. A third group of base variables makes a value of the target function increase by 5.111111114 than the value of the target function corresponding to the base variable selected last time. Theoretically, the third group of base variables should be selected as the new group of base variables. However, because the values of the target function caused by the three groups of base variables differ slightly, specifically, values of eight decimal places are the same. Due to calculation precision, a computer cannot accurately determine which group of base variables can optimize the value of the target function fastest. The computer may have a calculation error, for example, consider that the second group of base variables can optimize the value of the target function fastest. In addition, the following problem may occur: When a new base variable is selected next time, it is considered that the first group of base variables can optimize the value of the target function fastest, and when a new base variable is selected next time, it is considered again that the second group of base variables can optimize the value of the target function fastest. As a result, "recycling" occurs, and the optimal solution cannot be output for a long time, or the final solution cannot be output.

For the foregoing problems, embodiments of this application provide a service data processing method, to improve efficiency of solving a linear programming problem. To better understand the solutions provided in embodiments of this application, the following first describes an example of a system architecture to which the data processing method provided in embodiments of this application is applicable.

FIG. 1 is a schematic diagram of a system architecture according to an embodiment of this application. The system architecture of a system in this embodiment of this application may include an execution device and a server. The execution device may receive a requirement and data that are input by a user, and the data and the requirement may indicate a service problem. The execution device may send the requirement and the data to the server. The server invokes a linear programming module, to construct a target function and a constraint condition based on the requirement and the data input by the user. The linear programming module includes a processing module, configured to perform the data processing method provided in embodiments of this application, to obtain an optimal solution of the target function. The optimal solution of the target function indicates a programming solution of a service. It should be noted that, in a possible implementation, the linear programming model may also be deployed on the execution device, and the system may include only the execution device.

In some scenarios, the server may also generate a requirement and data based on an actual service problem, and the server may perform solving based on the data, to obtain a solution that can solve the actual service problem.

The user can input the requirement and the data on a client. The server and a client program are connected through a wired network or a wireless network. A standard communication technology and/or protocol is used for the wireless network. The wireless network is generally the internet, but may also be any network, including but not limited to a local area network (Local Area Network, LAN), a metropolitan area network (Metropolitan Area Network, MAN), a wide area network (Wide Area Network, WAN), a mobile network, a private network, or any combination of virtual private networks. In other embodiments, a customized or dedicated data communication technology may be used to replace or supplement the foregoing data communication technology. In an implementation, the client may be generated in the server, and the server sends the generated client to the execution device through the wireless network or the wired network, or the client may be configured on the execution device by using a removable storage device.

The requirement and the data can be received on the client, in actual application, further, the requirement and the data may be received in another form. For example, the user may further input the requirement and the data on a web page in a manner of invoking an API on the web page. This is not limited in embodiments of this application.

The execution device may be a computer workstation, a personal computer, a tablet computer, a notebook computer, or a personal computer (personal computer, PC). This is not limited herein. Although FIG. 1 shows only one server and one execution device, it should be understood that the example in FIG. 1 is merely used to understand this solution. A specific quantity of servers and a specific quantity of execution devices should be flexibly determined based on an actual situation.

The following describes the system architecture in embodiments of this application with reference to several specific application scenarios.

For example, in a vehicle scheduling scenario, the execution device or the server may generate a vehicle scheduling requirement, and input conditions such as a route requirement and a travel duration requirement for each vehicle into the linear programming module. The linear programming module constructs a target function and a constraint condition based on obtained data. The execution device or the server invokes a solver to perform the data processing method provided in embodiments of this application, to obtain an optimal solution of the target function. The optimal solution of the target function indicates an optimal vehicle scheduling solution, and the execution device may feed back the optimal scheduling solution.

For another example, when programming a factory production plan, that is, factory production scheduling, a user may input data by using the execution device, where the data includes a quantity of factory production lines, a production capacity of each production line, a material required for production, or the like. The execution device sends the data to the linear programming module, and the linear programming module constructs a target function and a constraint condition based on the obtained data. The execution device or the server invokes a solver to perform the data processing method provided in embodiments of this application, to obtain an optimal solution of the target function. The optimal solution of the target function indicates optimal factory production scheduling, for example, a product type and a quantity of products produced by each production line each day can minimize processing costs, minimize processing time, and maximize an order fulfillment rate. The execution device may feed back the optimal factory production scheduling.

Based on the foregoing described system, embodiments of this application provide the service data processing method, to solve large-scale linear programming problems, for example, solve problems such as warehouse transfer, supply and demand simulation, multi-factory production scheduling, and vehicle scheduling, and improve efficiency of solving these linear programming problems. In embodiments of this application, in a process of selecting a base variable, a maximum heap structure is introduced, and the base variable can be selected based on data stored by a root node in the maximum heap structure. There is no need to perform a large quantity of comparison operations each time the base variable is selected. This manner can improve solving efficiency, and efficiently complete programming of warehouse transfer, supply and demand simulation, multi-factory production scheduling, and vehicle scheduling. The following describes in detail the data processing method provided in embodiments of this application with reference to specific embodiments.

FIG. 2 is a schematic flowchart of a service data processing method according to this application. Descriptions are as follows.

201: Obtain a target function and a constraint condition.

The target function indicates a solving target of a service problem. The target function includes a plurality of variables related to the service problem. For example, the target function may represent a minimum production amount or a maximum production amount of a factory production target, and the target function may include a variable related to a factory production amount, for example, a production amount of each production line or production duration of each production line.

The constraint condition indicates a restriction condition of the service problem, and the constraint condition includes a constraint relationship between a plurality of variables.

A server or an execution device may construct the target function and the constraint condition based on data input by a user, or a server and an execution device may construct the target function and the constraint condition based on data generated based on an actual requirement.

The constructed target function includes a decision variable and a sparse variable. The decision variable is a variable in the to-be-solved service problem, and a value of the decision variable obtained through subsequent solving may form the solving target. For example, the decision variable is a variable related to the factory production amount, and a variable having an actual meaning, such as the production amount of each production line or the production duration of each production line. To solve a linear programming problem, a linear programming standard type is required. The sparse variable is a variable introduced to construct the linear programming standard type. The linear programming standard type requires that the target function is of a maximum type, and all constraint conditions are equations.

Descriptions are provided below with reference to a specific example. It is assumed that a pharmaceutical factory produces two kinds of medicines A and B, and production of the two kinds of medicines needs to consume a specific vitamin. Table 1 shows a quantity of vitamins required to produce per ton of medicine, occupied device time, and a total amount of resources available to the factory every week. It is known that profits of the factory to produce per ton of medicines A and B are 50,000 yuan and 20,000 yuan respectively. However, according to results of market demand survey, a weekly output of the medicine A should not be greater than 3 tons. A solving target is how the factory should arrange outputs of the two medicines to maximize weekly profits.

**Table 1**

| | Consumption per ton of product | | Total amount of resources per week |
|---|---|---|---|
| | A | B | |
| Vitamin (kilogram) | 35 | 25 | 150 |
| Device (set) | 4 | 1 | 12 |

It is assumed that after a user inputs the foregoing data, the solving target is to maximize 5×1+2×2, where x1 indicates a planned production output of the medicine A, and x2 indicates a planned production output of the medicine B, x1 and x2 are actually to-be-solved variables, and are decision variables. For the foregoing problem, constraint conditions of x1 and x2 include:

$$\begin{cases} 35x1+25x2\leq 150 \\ 4x1+x2\leq 12 \\ x1\leq 3 \\ x1\geq 0,\ x2\geq 0 \end{cases}$$

To construct the linear programming standard type, variables x3 and x4 need to be introduced. Specifically, a target function is maxZ=5x1+2x2+0*x3+0*x4. Constraint conditions are as follows:

$$\begin{cases} 35x1+25x2+x3=150 \\ 4x1+x2+x4=12 \\ x1\leq 3 \\ x1\geq 0,\ x2\geq 0,\ x3\geq 0,\ x4\geq 0 \end{cases}$$

The variables x3 and x4 introduced to construct the linear programming standard type are sparse variables.

202: Select the at least one variable from the plurality of variables as an initial variable in a base variable group, and use a variable in the plurality of variables other than the variable included in the base variable group as an initial variable in a non-base variable group.

The plurality of variables include the decision variable and the sparse variable, and the variable in the base variable group is used to obtain the final solving target. Therefore, a quantity of variables included in the base variable group is determined based on a quantity of decision variables, or a quantity of variables included in the base variable group is determined based on a quantity of constraint conditions. If the quantity of decision variables is inconsistent with the quantity of constraint conditions, the quantity of variables included in the base variable group may be determined based on a smaller value of the two.

In an initial state, a fixed quantity of variables may be selected from the plurality of variables in a plurality of manners as initial variables in the base variable group. For example, all the initial variables in the base variable group may be selected from the sparse variables; or some variables may be selected from the sparse variables, and some variables may be selected from the decision variables, to jointly serve as the initial variables in the base variable group.

The base variable group and the non-base variable group may be represented in a plurality of forms. For example, two lists may be preset in a list manner. A variable selected as a base variable is added to the list corresponding to the base variable group, and a variable other than the variable selected as the base variable is added to the list corresponding to the non-base variable group. For another example, two different labels may be set for a base variable and a non-base variable in a manner of presetting a label. A variable selected as the base variable is added with the label indicating the base variable, and a variable other than the variable selected as the base variable is added with the label indicating the non-base variable. For still another example, two datasets may be preset in a dataset manner. A variable selected as a base variable is added to the dataset corresponding to the base variable group, and a variable other than the variable selected as the base variable is added to the dataset corresponding to the non-base variable group.

203: Sort optimized values of variables in the non-base variable group to obtain a maximum heap structure.
An optimized value of a variable may be obtained by using the following formula:

$$\sigma_j = k_j - \sum_{i=1, i \neq j}^{n} k_i \times m_i \quad (1\text{-}1)$$

$\sigma_j$ represents an optimized value of a variable j, and the variable j is any variable in the non-base variable group. $k_j$ represents a coefficient of the variable j in the target function. The coefficient may also be referred to as constant data. If the service problem is solving factory production scheduling, the constant data may include information that represents a service feature, such as a quantity of factory production lines, a type of a product produced by each production line, a production amount of each production line, or costs of producing a product by each production line. $k_1$ to $k_n$ each represent a coefficient of each variable in the base variable group in the target function. $m_1$ to $m_n$ each represent a coefficient of the variable j in the constraint condition. A larger value of $\sigma_j$ indicates a larger optimized value of the variable j. When the value of the variable j changes, an optimization rate of the target function is also larger.
The optimized value of the variable indicates the optimization rate of the target function when a value of the variable changes. If a value of each variable in the target function changes, a value of the target function changes. When values of variables whose value changes change to a same degree, changing a value of a variable can enable the value of the target function closest to the solving target, that is, a higher optimization rate indicates a larger optimized value of the variable.
It is assumed that the non-base variable group includes three variables: a variable 1 to a variable 3. Values of the variables 2 and 3 are fixed, and a value of the variable 1 is changed to increase the value of variable by 1. The variable 1 can enable the optimization rate of the value of the target function to be related to a coefficient of the variable 1 in the target function. For example, a larger coefficient of the variable 1 in the target function indicates that the value of the target function changes faster. A value range of the variable 1 is related to a coefficient of variable 1 in a constraint condition. In addition, whether changing the value of the variable 1 enables the value of the target function closer to the solving target than a current value is further related to a coefficient of the base variable in the target function. For a specific process, refer to Formula 1-1 for understanding. Similarly, values of the variables 1 and 3 are fixed, and a value of the variable 2 is changed, to increase the value of the variable 2 by 1; and values of the variables 1 and 2 are fixed, and a value of the variable 3 is changed, to increase the value of the variable 3 by 1. It is assumed that changing the value of the variable 1 may increase the value of the target function by 10, changing the value of the variable 2 may increase the value of the target function by 20, and changing the value of the variable 3 may increase the value of the target function by 30. If the solving target is to maximize the value of the target function, it may be considered that changing the value of the variable 3 can enable the value of the target function closest to the solving target, and it is considered that the optimized value of the variable 3 is larger. It should be noted that increasing a value of each variable by 1 is merely used to describe a variable whose value changes, and a same degree of value change. This constitutes no limitation. In addition, to better understand how to solve the optimized value, how to obtain the optimized value of the variable is described herein with reference to a specific example.
It is assumed that the target function is maxZ = $6x_1 - 2x_2 + x_3 + 0 * x_4 + 0 * x_5$, and the constraint conditions are as follows:

$$\begin{cases} 2x_1 - 1 * x_2 + 2x_3 + 1 * x_4 + 0 * x_5 = 2 \\ 1 * x_1 + 0 * x_2 + 4x_3 + 0 * x_4 + 1 * x_5 = 4 \\ x_1, x_2, x_3, x_4, x_5 \geq 0. \end{cases}$$

It is assumed that in an initial state, variables $x_4$, $x_5$ are selected as the initial variables in the base variable group, and $x_1$, $x_2$, $x_3$ are used as the initial variables in the non-base variable group. According to the target function and the constraint condition, it may be obtained that a coefficient of the variable $x_1$ in the target function is 6, coefficients of the variables $x_4$, $x_5$ in the target function are all 0, and coefficients of the variable $x_1$ in the constraint conditions are 2 and 1. Therefore, an optimized value of the non-base variable $x_1$ obtained by using Formula 1-1 is 6-(0*2+0* 1)=6. Similarly, it may be obtained that a coefficient of the variable $x_2$ in the target function is -2, coefficients of the variables $x_4$, $x_5$ in the target function are all 0, and coefficients of the variable $x_2$ in the constraint conditions are 1 and 0. Therefore, an optimized value of the non-base variable $x_1$ obtained by using Formula 1-1 is -2-(0*1+0*0)=-2. It may be obtained that a coefficient of the variable $x_3$ in the target function is 1, coefficients of the variables $x_4$, $x_5$ in the target function are all 0, and coefficients of the variable $x_3$ in the constraint conditions are 2 and 4. Therefore, an optimized value of the non-base variable $x_1$ obtained by using Formula 1-1 is 1-(0*2+0*4)=1. In a possible implementation, an optimized value of the base variable may be obtained, and a manner of obtaining the optimized value of the base variable is consistent with a manner of obtaining the optimized value of the non-base variable. For example, it may be obtained that a coefficient of the variable $x_4$ in the target function is 0, a coefficient of $x_5$ in the target function is 0, and coefficients of the variable $x_4$ in the constraint conditions are 1 and 0. Therefore, an optimized value of the non-base variable $x_4$ obtained by using Formula 1-1 is 0-(0* 1+0*0)=0. For another example, it may be obtained that a coefficient of the variable $x_5$ in the target function is 0, a coefficient of $x_4$ in the target function is 0, and coefficients of the variable $x_5$ in the constraint conditions are 0 and 1. Therefore, an optimized value of the non-base variable $x_5$ is obtained by using Formula 1-1 is 0-(0*0+0* 1)=0.

The optimized values of the variables in the non-base variable group are stored in a stack structure, and a maximum heap algorithm is invoked to sort the optimized values of the variables in the non-base variable group, to obtain the maximum heap structure. In a possible implementation, both the optimized values of the variables in the non-base variable group and optimized values of variables in the base variable group may be stored in the stack structure, and the maximum heap algorithm is invoked to sort the optimized values of the variables in the non-base variable group and the optimized values of the variables in the base variable group, to obtain the maximum heap structure. The maximum heap structure is characterized by that a root node has a largest keyword in keywords of all nodes in a heap. In embodiments of this application, a keyword in the maximum heap structure is an optimized value of a variable. In addition, in embodiments of this application, each node further stores an identifier of a variable, and the identifier of the variable is used to determine the unique variable. In other words, an identifier of each variable is unique, and one variable can correspond to only a unique identifier. The identifier of the variable may be represented in different manners. For example, the identifier of the variable may be a number, and each variable corresponds to a number. For another example, the identifier of the variable may be an index, and each variable corresponds to one index. A specific representation manner of the identifier is not limited in embodiments of this application. FIG. 3 is a schematic diagram of the maximum heap structure in this embodiment of this application. An optimized value of each variable and an identifier of the variable are stored by each node in a form of a key-value pair. An optimized value of a variable stored by the root node in the maximum heap structure is a largest optimized value in all optimized values stored in the stack structure. It should be noted that the maximum heap structure shown in FIG. 3 includes five nodes, and is merely an example and does not represent a limitation. It can be learned from the foregoing description that a quantity of nodes included in the maximum heap structure is determined based on a quantity of variables included in the base variable group, or is determined based on a total quantity of variables.

204: Update the non-base variable group and the base variable group based on a first target variable, where the first target variable is a variable corresponding to an identifier stored by the root node in the maximum heap structure.

A process of obtaining the solving target of the target function includes a process of repeatedly selecting a new base variable. In this embodiment of this application, in the process of selecting the new base variable, the new base variable needs to be obtained only based on the variable corresponding to the identifier stored by the root node in the maximum heap structure, without repeatedly executing a comparison algorithm for a plurality of times. Specifically, in the process of selecting the new base variable, a for loop statement generally needs to be invoked for a plurality of times, to execute the comparison algorithm. This can obtain the base variable that can optimize the value of the target function fastest. This process is time-consuming. However, in this embodiment of this application, the stack structure is introduced, to store the optimized values of the variables, and the maximum heap algorithm is invoked to sort the optimized values of the variables, to obtain the maximum heap structure. The new base variable can be directly obtained based on the variable corresponding to the identifier stored by the root node in the maximum heap structure. This accelerates a calculation process of selecting the base variable.

Specifically, the first target variable may be exchanged with a second target variable in the base variable group, to update the variable in the base variable group and the variable in the non-base variable group. How to select the second target variable in the base variable group is not limited in embodiments of this application. A person skilled in the art may select the second target variable in different manners. For example, the second target variable is a base variable that is first reduced to 0 as the first target variable increases and that is found by using a minimum ratio calculation method.

205: Obtain the solving target of the service problem based on a variable in an updated base variable group and the constraint condition.

Compared with a value of the target function obtained based on the initial variable in the base variable group, the value of the target function obtained based on the variable in the updated base variable group is closer to the solving target. In different services, the solving target may have different service meanings. For example, in a production scheduling service, the solving target may be a generation plan with lowest production costs and shortest production time; and in a traffic service, the solving target may be a traffic light display solution with shortest waiting time of a vehicle and a pedestrian in each direction of an intersection. This is not specifically limited herein.

A value of a variable in an updated non-base variable group is set to 0, and the variable in the non-base variable group is substituted into the constraint condition, so that a value of the variable in the base variable group can be obtained. The value of the variable in the base variable group is substituted into the target function, so that the value of the target function can be obtained.

If the base variable group is updated only once, the solving target may be obtained based on the variable in the base variable group. This completes a task of obtaining the solving target. For example, if replacing any base variable in the current base variable group, or selecting any non-base variable from the non-base variable group to replace a base variable in the current base variable group does not enable the value of the target function more optimal, it is considered that a value of a variable in the current base variable group is an optimal solution.

However, generally, if the base variable group is updated only once, the solving target usually cannot be obtained. The base variable group, the non-base variable group, and the maximum heap structure need to be iteratively updated for a plurality of times until the solving target is obtained. This is described in detail below.

After the first target variable is exchanged with the second target variable in the base variable group, the maximum heap structure may be updated based on the second target variable.

In a possible implementation, if the initial maximum heap structure is obtained after the optimized values of the variables in the non-base variable group and the optimized values of the variables in the base variable group are sorted, an optimized value of the first target variable may be recalculated. A specific calculation manner is described above. Details are not described herein again. An optimized value of the first target variable stored in the initial maximum heap structure is updated based on the optimized value, of the first target variable, obtained through recalculation. As shown in FIG. 4, an advantage of this implementation is as follows: The maximum heap structure does not need to be totally updated, and only data stored by one node in the maximum heap structure needs to be updated. This further reduces a calculation amount. In this implementation, it is approximately considered that optimized values of other variables do not change. The first target variable was once stored by the root node in the maximum heap structure. After the first target variable and the second target variable are exchanged, the optimized value of the first target variable changes significantly. It may be understood that the value of the target function is optimized based on the first target variable. On this basis, if the value of the first target variable changes again, the optimization rate of the target function does not increase. A theoretical basis for approximately considering that the optimized values of the other variables do not change is that an optimized value of each variable is related to a coefficient of the variable in the target function, a coefficient of the variable in the constraint condition, and a coefficient of the base variable in the target function (understanding with reference to Formula 1-1). The first target variable is exchanged with the second target variable in the base variable group, and two of the three factors that affect the optimized value of the variable do not change, that is, the coefficient of the variable in the target function, and the coefficient of the variable in the constraint condition do not change. Therefore, in this implementation, it is approximately considered that the optimized values of the other variables do not change, and only the optimized value of the first target variable whose optimized value changes most is updated. After the optimized value of the first target variable is updated, the maximum heap algorithm is invoked again to sort optimized values in the maximum heap structure, to update the maximum heap structure. In other words, the maximum heap algorithm is invoked to adjust a location of each node in the maximum heap structure based on an optimized value stored in each node. Refer to FIG. 4 for understanding. The optimized value stored by the root node in the maximum heap structure is updated, and data stored by other nodes remains unchanged. On this basis, the maximum heap algorithm is invoked to adjust a location relationship between nodes in the maximum heap structure based on the optimized value stored by each node, to meet a feature of the maximum heap structure, that is, the optimized value stored by the root node is largest. This manner can greatly reduce the calculation amount in the process of selecting the base variable, and further improve a solving speed.

Optionally, an optimized value of the first target variable and an optimized value of the second target variable are further updated. After the optimized value of the first target variable and the optimized value of the second target variable are updated, the maximum heap algorithm is invoked again to sort optimized values in the maximum heap structure, to update the maximum heap structure. In other words, the maximum heap algorithm is invoked to adjust a location of each node in the maximum heap structure based on an optimized value stored in each node. Refer to FIG. 5 for understanding. The optimized value of the first target variable and the optimized value of the second target variable are updated, and data stored by other nodes remains unchanged. On this basis, the maximum heap algorithm is invoked to adjust a location relationship between nodes in the maximum heap structure based on the optimized value stored by each node, to meet a feature of the maximum heap structure, that is, the optimized value stored by the root node is largest. An advantage of this implementation is as follows: The maximum heap structure does not need to be totally updated, and only data stored by the two nodes needs to be updated. This reduces a calculation amount. In this implementation, it is approximately considered that optimized values of other variables do not change, and only the optimized value of the first target variable whose optimized value changes most and the optimized value of the second target variable related to the current iterative update processing are updated.

Optionally, optimized values of variables in an updated non-base variable group may be recalculated, and optimized values of variables in the non-base variable group that are obtained after the recalculation are sorted, to update the maximum heap structure.

Optionally, optimized values of variables in an updated non-base variable group and optimized values of variables in the base variable group may be recalculated, and optimized values of variables in the non-base variable group and optimized values of variables in the base variable group that are obtained after recalculation are sorted, to update the maximum heap structure.

In a possible implementation, if the initial maximum heap structure is obtained after the optimized values of the variables in the non-base variable group are sorted, the optimized value of the second target variable may be calculated, and the optimized value is added to the stack, to update the maximum heap structure. It should be noted that, in this implementation, the initial maximum heap structure is obtained after the optimized values of the variables in the non-base variable group are sorted. After the first target variable is added to the base variable group, the maximum heap structure no longer stores the optimized value corresponding to the first target variable.

Each time the base variable group and the non-base variable are updated, the maximum heap structure can be updated. In other words, each time the root node in the maximum heap structure selects a base variable, the base variable group and the non-base variable group are updated. This process is repeated to iteratively update the base variable group, the non-base variable, and the maximum heap structure until a stop condition is met. In a possible implementation, the stop condition includes that a quantity of iterative updates reaches a threshold. For example, it is preset that the iterative update is stopped after the iterative update is performed for 50 times, and a value of the target function obtained based on a variable in the current base variable group is the solving target. In a possible implementation, the stop condition includes that the optimized value stored by the root node in the maximum heap structure is less than a threshold. For example, if it is preset that the optimized value stored by the root node in the maximum heap structure is less than 0.01, the iterative update is stopped, and a value of the target function obtained based on a variable in the current base variable group is the solving target.

In addition, it should be noted that the foregoing several manners of updating the maximum heap structure may be used in combination. For example, during previous iterative updates, the maximum heap structure is progressively updated. Only optimized values of some variables are recalculated, only the optimized values of some variables in the maximum heap structure are updated, and optimized values of other variables are not updated. As the quantity of iterations increases, the manner can be switched to a manner of updating the maximum heap structure as a whole. An optimized value of each current non-base variable or an optimized value of each current variable is recalculated, and the maximum heap structure is updated based on a recalculated optimized value of each non-base variable or optimized value of each variable. For example, the manner of updating the maximum heap structure as a whole is performed once every 10 times of progressive update of the maximum heap structure. This manner can accelerate a solving speed, and ensures solving precision. A quantity of times for progressively updating the maximum heap structure and a quantity of times for updating the maximum heap structure as a whole may be set based on an actual requirement, to find a balance between the solving speed and the solving precision.

In the embodiment corresponding to FIG. 2, in the process of selecting the base variable, the maximum heap structure is introduced, and the new base variable is obtained based on the variable corresponding to the identifier stored by the root node in the maximum heap structure. This improves a speed of selecting the new base variable, and further accelerates a speed of obtaining the solving target.

In the embodiment corresponding to FIG. 2, iterative updates of the base variable group, the non-base variable, and the maximum heap structure are described, where one stop condition includes that the optimized value stored by the root node in the maximum heap structure is less than the threshold. Theoretically, an optimal stop condition is when the optimal value stored by the root node in the maximum heap structure is 0. The optimized value stored by the root node in the maximum heap structure is 0, which means that when a value of any variable in the current non-base variable changes, the value of the target function cannot be optimized. In this case, the value of the variable in the current base variable group is the optimal solution of the target function. However, it is also described above that, due to calculation precision of the server or the execution device, degeneracy may occur. As a result, the optimal stop condition cannot be reached, and the optimal solution of the target function cannot be obtained. To resolve degeneracy in a process of searching for the optimal solution of the target function, in embodiments of this application, statistics may be collected on identifiers stored by the root node in the maximum heap structure, and a variable corresponding to a target identifier is selected as the base variable based on a quantity of times that each identifier is stored by the root node and that is indicated by a statistical result. Descriptions are provided in detail below with reference to a specific embodiment.

FIG. 6 is a schematic flowchart of another service data processing method according to this application. Descriptions are as follows.

601: Obtain a target function and a constraint condition.

602: Select at least one variable from a plurality of variables as an initial variable in a base variable group, and use a variable in the plurality of variables other than the variable included in the base variable group as an initial variable in a non-base variable group.

603: Sort optimized values of variables in the non-base variable group to obtain a maximum heap structure.

Step 601 to step 603 may be understood with reference to step 201 to step 203 in the embodiment corresponding to FIG. 2. Details are not described herein again.

604: Obtain a first parameter based on the maximum heap structure.

First K largest optimized values in the maximum heap structure are obtained, where K is a positive integer greater than 1. The first parameter is obtained based on a difference value between a largest optimized value and a smallest optimized value in the first K largest optimized values. For example, if K is 3, first three largest optimized values in the maximum heap structure are obtained, where a root node stores a largest optimized value, and a second largest optimized value and a third largest optimized value are obtained from child nodes adjacent to the root node. The first parameter is obtained based on a difference value between the largest optimized value and the third largest optimized value.

The first parameter is used to measure the difference between the first K largest optimized values in the maximum heap structure. If there is a huge difference between the first K largest optimized values, that is, the first parameter is large, it is considered that a server or an execution device can accurately distinguish the K optimized values, and accurately sort the K optimized values. Therefore, step 605 of updating the non-base variable group and the base variable group based on a first target variable, where the first target variable is a variable corresponding to an identifier stored by a root node in the maximum heap structure is performed.

Step 605 may be understood with reference to step 204 in the embodiment corresponding to FIG. 2. Details are not described herein again.

As described above, degeneracy may occur in a process of continuously selecting new base variables. That is, in a process of iteratively updating the base variable group, the non-base variable, and the maximum heap structure continuously, the value of the target function is not continuously optimized, or a problem that an optimal solution cannot be output occurs. In this embodiment of this application, the first parameter is introduced, and statistics are collected on the identifiers stored by the root node in the maximum heap structure. When degeneracy occurs, a reasonable non-base variable can still be obtained and added to the base variable group, to perform last update on the base variable group and the non-base variable.

For example, if there is a small difference between the first K largest optimized values, that is, the first parameter is small, it is considered that a server or an execution device cannot accurately distinguish the K optimized values, and cannot accurately sort the K optimized values. In other words, if there is a small difference between the first K largest optimized values, it is considered that calculation precision of the server or the execution device is insufficient to ensure that an optimized value stored by the root node in the maximum heap structure is definitely the largest optimized value in the K largest optimized values. For example, the calculation precision of the server or the execution device is eight decimal places. It is assumed that the obtained first parameter is 0.00000000523, and the first parameter includes 11 decimal places, and exceeds the calculation precision of the server or the execution device. In this case, it is not appropriate to update the non-base variable group and the base variable group based on the variable corresponding to the identifier stored by the root node in the maximum heap structure. If the non-base variable group and the base variable group are still updated based on a variable corresponding to the identifier stored by the root node in the maximum heap structure, degeneracy may occur. Therefore, in this case, step 606 of updating the non-base variable group and the base variable group based on a variable corresponding to a target identifier is performed. When degeneracy occurs, values of variables are close to the optimal solution. After step 606 is performed, the base variable group and the non-base variable group are not updated anymore, and a solving target is obtained based on values of variables in the current base variable group. The following describes step 606 in detail.

Statistics are collected on a quantity of times that K identifiers have been stored by the root node in the maximum heap structure, and the target identifier is an identifier in the K identifiers that has been stored by the root node in the maximum heap structure for a smallest quantity of times. Optimized values of variables corresponding to the K identifiers are the K largest optimized values. For example, the K identifiers include an identifier 1, an identifier 2, and an identifier 3. In the obtained maximum heap structure in historical iterative update processing, the identifier 1 is stored by the root node in the maximum heap structure for five times, the identifier 2 is stored by the root node in the maximum heap structure for two times, and the identifier 3 is stored by the root node in the maximum heap structure for six times. It can be learned that the identifier 2 has been stored by the root node in the maximum heap structure for a smallest quantity of times. Regardless of whether the root node in the current maximum heap structure stores the identifier 2, the base variable group and the non-base variable group are updated based on a variable corresponding to the identifier 2. That is, after the variable corresponding to identifier 2 is exchanged with a variable in the base variable group, a final base variable group is obtained. Theoretically, a base variable selected each time is different, that is, each time a different non-base variable is added to the base variable group, to update the base variable group. Theoretically, the non-base variable that has been selected and added to the base variable group will not be replaced from the base variable group. Therefore, when degeneracy occurs, the K variables may be repeatedly selected, added to the base variable group, and then replaced. In a plurality of update processes, a larger quantity of times that an identifier corresponding to a variable is stored by the root node indicates a higher probability that the variable is selected, added to the base variable group, and then replaced, and it indicates that the variable is not appropriate for being used as the base variable. Therefore, it is inclined to select, from the K variables, a variable with a lowest probability of being selected and added to the base variable group in historical iterative update processing (that is, a variable corresponding to an identifier stored by the root node for the smallest quantity of times).

It should be noted that the first parameter may be obtained based on a maximum heap structure obtained in each iteration update processing, to determine whether to update the non-base variable group and the base variable group based on the variable corresponding to the identifier stored by the root node in the maximum heap structure or update the non-base variable group and the base variable group based on the variable corresponding to the target identifier. In addition, after fixed times of iterative update processing are completed, the first parameter may be obtained based on a maximum heap structure obtained in each iterative update processing. For example, in first 10 times of iterative update processing, the first parameter is not obtained based on the maximum heap structure, and the non-base variable group and the base variable group are updated based on the variable corresponding to the identifier stored by the root node in the maximum heap structure. In eleventh and subsequent iterative update processing, the first parameter may be obtained based on a maximum heap structure obtained in each iterative update processing, to determine whether to update the non-base variable group and the base variable group based on the variable corresponding to the identifier stored by the root node in the maximum heap structure or update the non-base variable group and the base variable group based on the variable corresponding to the target identifier. Alternatively, the first parameter may be obtained once after each fixed time of iterative update processing. For example, in first 10 times of iterative update processing, the first parameter is not obtained based on the maximum heap structure, and the non-base variable group and the base variable group are updated based on the variable corresponding to the identifier stored by the root node in the maximum heap structure. In eleventh iterative update processing, the first parameter is obtained, to determine whether to update the non-base variable group and the base variable group based on the variable corresponding to the identifier stored by the root node in the maximum heap structure or update the non-base variable group and the base variable group based on the variable corresponding to the target identifier. If it is determined that the non-base variable group and the base variable group are updated based on the variable corresponding to the identifier stored by the root node in the maximum heap structure, in twelfth to twentieth iterative update processing, the first parameter is not obtained based on the maximum heap structure, and the non-base variable group and the base variable group are updated based on the variable corresponding to the identifier stored by the root node in the maximum heap structure. In twenty-first iterative update processing, the first parameter is obtained, to determine whether to update the non-base variable group and the base variable group based on the variable corresponding to the identifier stored by the root node in the maximum heap structure or update the non-base variable group and the base variable group based on the variable corresponding to the target identifier, and so on.

In addition, in addition to the foregoing mentioned manner of determining, based on the difference that is between the first K largest optimized values in the maximum heap structure and that is measured based on the first parameter, whether to update the non-base variable group and the base variable group based on the variable corresponding to the identifier stored by the root node in the maximum heap structure or update the non-base variable group and the base variable group based on the variable corresponding to the target identifier, Another manner may alternatively used to determine whether to update the non-base variable group and the base variable group based on the variable corresponding to the identifier stored by the root node in the maximum heap structure or update the non-base variable group and the base variable group based on the variable corresponding to the target identifier. In this embodiment of this application, degeneracy can be found in time by collecting statistics on the identifiers stored by the root node in the maximum heap structure. For example, statistics are collected on the identifiers stored by the root node in the maximum heap structure. For example, in an initial state, an identifier stored by the root node in the maximum heap structure is an index 1. After the maximum heap structure is updated for a first time, an identifier stored by the root node in the maximum heap structure is an index 2. After the maximum heap structure is updated for a second time, an identifier stored by the root node in the maximum heap structure is an index 3. After the maximum heap structure is updated for an $n^{th}$ time, an identifier stored by the root node in the maximum heap structure is an index n. After the maximum heap structure is updated for an $(n+1)^{th}$ time, an identifier stored by the root node in the maximum heap structure is an index n+1. After the maximum heap structure is updated for an $(n+2)^{th}$ time, an identifier stored by the root node in the maximum heap structure is an index n+2. After the maximum heap structure is updated for an $(n+3)^{th}$ time, an identifier stored by the root node in the maximum heap structure is the index n. At this point, the index n is stored by the root node in the maximum heap structure for a second time, and it may be considered that degeneracy occurs in this case. In a possible implementation, it may be considered that the index n is the target identifier, and the non-base variable group and the base variable group are updated for a last time based on a variable corresponding to the index n. In a possible implementation, when it is determined that degeneracy occurs, the non-base variable group and the base variable group may be updated repeatedly based on the variables corresponding to the identifiers stored by the root node in the maximum heap structure, and an identifier is randomly selected from the identifiers stored by the root node in the maximum heap structure for a plurality of times as the target identifier. For example, after the maximum heap structure is updated for an $(n+4)^{th}$ time, the identifier stored by the root node in the maximum heap structure is the index n. The maximum heap structure continues to be updated. It is assumed that after the maximum heap structure is updated for an $(n+5)^{th}$ time, an identifier stored by the root node in the maximum heap structure is the index n+2. After the maximum heap structure is updated for an $(n+6)^{th}$ time, an identifier stored by the root node in the maximum heap structure is the index n+1. After the maximum heap structure is updated for an $(n+7)^{th}$ time, an identifier stored by the root node in the maximum heap structure is the index n. After the maximum heap structure is updated for an $(n+8)^{th}$ time, an identifier stored by the root node in the maximum heap structure is the index n+2. After the maximum heap structure is updated for an $(n+9)^{th}$ time, an identifier stored by the root node in the maximum heap structure is the index n+2. If the identifiers stored by the root node in the maximum heap structure for a plurality of times include the index n, the index n+1, and the index n+2, one identifier is randomly selected from the index n, the index n+1, and the index n+2 as the target identifier. For example, the index n+1 is selected as the target identifier, and the non-base variable group and the base variable group are updated for a last time based on a variable corresponding to the index n+1. In a possible implementation, an identifier stored for a smallest quantity of times may be selected from identifiers stored by the root node in the maximum heap structure for a plurality of times as the target identifier. It is assumed that after the maximum heap structure is updated for a $(n+10)^{th}$ time, the maximum heap structure stores the index n for three times, stores the index n+1 for two times, and stores the index n+2 for four times. It can be learned from historical statistics that a probability that the index n+1 is stored by the root node in maximum heap is lowest. In this case, the index n+1 is used as the target identifier, and the non-base variable group and the base variable group are updated for a last time based on a variable corresponding to the index n+1.

607: Obtain the solving target of a service problem based on a variable in an updated base variable group and the constraint condition.

In a possible case, the solving target of the service problem is obtained based on the constraint condition and the variable, in the base variable group, obtained when the stop condition is met.

In a possible case, the solving target of the service problem is obtained based on the constraint condition and the base variable group updated based on the variable corresponding to the target identifier.

Specifically, how to obtain the solving target of the service problem based on the variable in the base variable group and the constraint condition is described in the embodiment corresponding to FIG. 2. Details are not described herein again.

The foregoing describes the procedure of the data processing method provided in this application. The following further describes the procedure of the data processing method provided in this application by using an example with reference to a specific application scenario. With reference to FIG. 7, the following describes a procedure of a production plan generation method according to this application.

It should be understood that the production plan generation method provided in this application is associated with the foregoing data processing method. The foregoing service problem is specified as a production scheduling problem, which is described below in detail.

701: Obtain a target function and a constraint condition, where the target function indicates to solve a production product production plan.

The target function includes variables related to the generation plan. The constraint condition includes a constraint relationship between the variables related to the generation plan.

The step is similar to the foregoing step 201, and a difference lies in that a corresponding service problem is indicating solving the production product production plan. A coefficient of the target function includes a production target of a to-be-produced product in a period of time and/or a parameter for producing the product, or the like. The production target is a minimum quantity, a maximum quantity, or the like of the to-be-produced products, the production target may be represented by using the target function, the target function has a to-be-solved decision variable, and a value of the decision variable obtained after solving can form the production plan.

For example, constant data may include information such as a target quantity of products that are required to be produced in March, a quantity of factories, a quantity of production lines of each factory, a material, costs, or a cycle required for producing one product.

702: Select at least one variable from a plurality of variables as an initial variable in a base variable group, and use a variable in the plurality of variables other than the variable included in the base variable group as an initial variable in a non-base variable group.

The plurality of variables include the decision variable and a sparse variable, and the variable in the base variable group is used to obtain a final solving target. Therefore, a quantity of variables included in the base variable group is determined based on a quantity of decision variables, or a quantity of variables included in the base variable group is determined based on a quantity of constraint conditions. If the quantity of decision variables is inconsistent with the quantity of constraint conditions, the quantity of variables included in the base variable group may be determined based on a smaller value of the two.

703: Sort optimized values of variables in the non-base variable group to obtain a maximum heap structure.

In a production scheduling problem, tens of millions of decision variables are usually related, including a planned production amount, a delivery amount, a transportation amount, and the like. A quantity of constraint conditions is also very large, including a capacity constraint, an inventory constraint, and the like. When the quantity of variables or the quantity of constraint conditions increases, if a for loop statement is used to execute a comparison algorithm, a base variable that can optimize a value of the target function fastest is obtained. This process is time-consuming. However, in this embodiment of this application, a stack structure is introduced, to store the optimized values of the variables, and a maximum heap algorithm is invoked to sort the optimized values of the variables, to obtain the maximum heap structure. A new base variable can be directly obtained based on a variable corresponding to an identifier stored by a root node in the maximum heap structure. This accelerates a calculation process of selecting the base variable.

704: Update the non-base variable group and the base variable group based on a first target variable, where the first target variable is the variable corresponding to the identifier stored by the root node in the maximum heap structure.

705: Obtain the solving target of the service problem based on a variable in an updated base variable group and the constraint condition.

Steps 701 to 705 are similar to steps 201 to 205. Details are not described in this embodiment of this application.

With reference to a specific application scenario of a production scheduling problem, the following further describes a procedure of the data processing method provided in this application by using an example. FIG. 8 is a schematic flowchart of still another service data processing method according to this application.

First, input data is obtained, where the input data includes constant data and an input expression (namely, a constraint condition).

For example, if a production plan in a period of time needs to be arranged, the constant data may include a quantity of products produced in a period of time, and the input expression may include a production capacity of a device in a factory in a period of time, for example, a corresponding expression such as a quantity of devices, a type of a product produced by each device, duration spent by each device in producing a product, or a relationship thereof. A specific parameter in the expression, such as a quantity of devices, a type of a product produced by each device, and duration spent by each device in producing a product may be carried in the constant data.

After the constant data and the input expression are obtained, the production scheduling problem can be modeled, to construct a linear programming standard type. A sparse variable is introduced, so that a target function is of a maximum type, and all constraint conditions are equations. The target function and the constraint condition are preprocessed. For example, simplified processing is performed on the target function and the constraint condition. Specifically, the processing may include combining linearly related constraints, and modifying the constant data to integer constant data, for example, modifying 3.3 to 3. A data preprocessing process may further include other steps, for example, performing desensitization processing and noise reduction processing on data. Specifically, the data preprocessing may be adjusted based on an actual application scenario. This is not limited in embodiments of this application. Preprocessed data is input into a solver, and the solver may perform one or more implementations of the data processing method provided in this embodiment of this application. For example, the solver executes an embodiment related to solving policy selection, to determine whether to update a non-base variable group and a base variable group based on a variable corresponding to an identifier stored by a root node in a maximum heap structure or update a non-base variable group and a base variable group based on a variable corresponding to a target identifier. Corresponding to different solving policies, a solving target of a service problem is obtained based on the constraint condition and a variable, in the base variable group, obtained when a stop condition is met, or a solving target of a service problem is obtained based on the constraint condition and a base variable group updated based on the variable corresponding to the target identifier.

For further ease of understanding, the following describes application scenarios of the data processing method and the production plan generation method provided in this application by using examples.

For example, the data processing method and the production plan generation method provided in this application are applied to supply and demand simulation, thereby outputting a more accurate decision-making manner with higher efficiency.

Specifically, for example, the data processing method provided in this application is applied to a plurality of problems that can be solved through linear programming, for example, a production planning problem in a supply chain and a constraint routing problem in a network. A form of linear programming may be represented as follows.

A target function is $\min c^T x$

Constraint items are s. t. $Ax \geq b$ and $x \geq 0$.

$x$ is a variable, namely, a to-be-decided variable in a service problem; and A, b, c are usually known constants, where A is a coefficient matrix, b is a resource limit, and c is a target coefficient.

Descriptions are provided below by using a specific application scenario as an example.

1. Production plan

A production plan in a supply chain, as a special supply and demand matching problem, aims to decide how to optimally use raw materials to meet a customer requirement. A decision-making process includes production, transportation, and procurement, and is restricted by constraints such as an upper limit of a factory production capacity and an item processing structure. For example, a production target may include 2000 desktop computers, 1000 displays, and 800 notebook computers. There are two factories, each factory has a processing capacity of 1000 sets per day, and one display is required to process one desktop computer. When the production plan is considered, a processing order, amount, time, location, and the like of the desktop computers, displays, and notebook computers are decided.

To solve this type of problem, a linear programming manner may be generally used to perform modeling and solving on the problem. For example, the following model is a programming model for a production plan problem, and is represented as follows.

Target function:

$$\min \sum_{t=1}^{n} (p_t x_t + h_t s_t + q_t y_t)$$

Constraint conditions:

$$\text{s.t. } s_t + x_t - d_t = s_{t+1} (t = 1, \ldots n)$$

$$s_0 = s_n = 0,$$

$$x_t \le M_t y_t, (t = 1, \ldots, n),$$

$$\ldots$$

$$x \in \mathbb{R}_+^n,$$

$$s \in \mathbb{R}_+^{n+1},$$

$$y \in \{0,1\}^n.$$

t represents a time dimension, and a to-be-decided production amount in n days in the problem; $p_t$, $q_t$, $h_t$, $d_t$ are constants in the problem, and respectively represents production costs, fixed production costs, unit inventory costs, and a requirement of a $t^{th}$ day; and $x_t$, $y_t$, $s_t$ are variables in the problem, where $x_t$ represents a production amount at a moment t, $s_t$ represents an ending inventory amount at a moment t, and $y_t$ represents whether an item is produced at a moment t.

A first item in the constraint conditions is an "inventory update equation", and indicates inventory of a $(t+1)^{th}$ day that equals to inventory of the $t^{th}$ day plus a production amount of the $t^{th}$ day minus requirement consumption of the $t^{th}$ day.

It should be noted that the foregoing variables are only some variables, and an actual production scheduling problem may include tens of millions of decision variables. The foregoing constraint conditions are only some constraint conditions, and the actual production scheduling problem may include constraint conditions that are more complex than those in the example scenario. For ease of description, descriptions are not listed one by one herein. Because there is a large quantity of decision variables and a large quantity of constraint conditions, the large quantity of decision variables is also introduced in construction of the linear programming standard type. How to construct the linear programming standard type is described above. Details are not described herein again. Some variables are selected, as base variables, from the decision variables $x_t$, $y_t$, $s_t$ and sparse variables introduced for construction of the linear programming standard type, and another variable is selected as a non-base variable. A stack structure is introduced, to store optimized values of variables, and a maximum heap algorithm is invoked to sort the optimized values of the variables, to obtain a maximum heap structure. A new base variable can be directly obtained based on the variable corresponding to the identifier stored by the root node in the maximum heap structure. The production plan is obtained based on a variable in an updated base variable group and the constraint condition. In some implementations, the base variable group, the non-base variable group, and the maximum heap structure may need to be updated iteratively for a plurality of times to obtain an optimal production plan. For example, as shown in FIG. 9, the production plan includes the processing order, amount, time, location, and the like of the desktop computers, the displays, and the notebook computers. For example, 1000 displays are separately produced in two factories on a first day, then one of the factories separately uses the 2000 displays produced on the first day to produce desktop computers on a second day and a third day, and the other factory separately produces 1000 displays and 800 notebook computers on the second day and the third day.

Therefore, in this implementation of this application, the stack structure can be introduced, to store the optimized values of the variables, and the maximum heap algorithm is invoked to sort the optimized values of the variables, to obtain the maximum heap structure. The new base variable can be directly obtained based on the variable corresponding to the identifier stored by the root node in the maximum heap structure. This accelerates a calculation process of selecting the base variable. Further, statistics are collected on identifiers stored by the root node in the maximum heap structure, and a variable corresponding to an identifier with a smallest quantity of times is selected as the base variable based on a quantity of times that each identifier is stored by the root node and that is indicated by a statistical result. This avoids degeneracy in a solving process.

2. Logistics programming

The solutions provided in this application are applied to various problems that can be solved through linear programming, for example, a network flow problem in the logistics field. Herein, descriptions are provided by using a minimum-cost flow problem (minimum-cost flow problem) in a network flow as an example.

The minimum-cost flow problem is to find an optimal path in a flow network to send a specified quantity of supplies from a specified start to a specified end. A path may have a plurality of points, and there are costs between two points. Therefore, the optimal path is usually a path with lowest total transportation costs.

A programming model may be described as follows: It is assumed that there is a flow network $G = (V, E)$, $V$ represents all transportation nodes, $s \in V$ is a start, $t \in V$ is an end, and $E$ represents all edges, namely, a connection line between points. $a(u, v)$ and $f(u, v)$ are defined to indicate unit transportation costs and transportation amount respectively from a node $u$ to a node $v$. When a required transportation amount is $d$, a problem programming model is as follows.

A target function is expressed as follows: (for example, the lowest total transportation costs) $\Sigma_{(u,v)\in E} a(u, v). f(u, v)$.

Constraint conditions are as follows:

$$f(u,v) \leq c(u,v)$$

$$f(u,v) = -f(v,u)$$

$$\sum_{w \in V} f(u,w) = 0 \; for \; all \; u \neq s,t$$

$$\sum_{w \in V} f(s,w) = d \; and \; \sum_{w \in V} f(w,t) = d$$

...

A first constraint item is "a transportation amount upper limit", that is, there is an upper limit for a transportation amount between two points; a third constraint item is "a flow conservation constraint"; and a fourth constraint item indicates that an inflow amount of the start and an outflow amount of the end should be equal to the required amount $d$.

It should be noted that actual logistics programming may include tens of millions of decision variables and constraint conditions that are more complex than those in the example scenario. For ease of description, descriptions are not listed one by one herein. Some variables are selected, as base variables, from the decision variables (for example, the foregoing listed variable E) and sparse variables introduced for construction of the linear programming standard type, and another variable is selected as a non-base variable. A stack structure is introduced, to store optimized values of variables, and a maximum heap algorithm is invoked to sort the optimized values of the variables, to obtain a maximum heap structure. A new base variable can be directly obtained based on a variable corresponding to an identifier stored by a root node in the maximum heap structure. The optimal transportation path is obtained based on a variable in an updated base variable group and the constraint condition. In some implementations, the base variable group, the non-base variable group, and the maximum heap structure may need to be updated iteratively for a plurality of times to obtain the optimal transportation path.

The following describes, with reference to experimental data, effect of improving a solving speed and solving stability of the data processing method provided in this application. In an experiment, 31 real production scheduling tasks are selected, and duration required for generating each production scheduling task by using a solver CLP and duration required for generating each production scheduling task by using the solver to which the data processing method provided in this application is applied are collected. The solver to which the data processing method provided in this application is applied is totally the same as the solver CLP in terms of solving precision. Therefore, the solving precision is not shown herein. On a premise of consistent solving precision, the solver to which the data processing method provided in this application is applied can significantly improve a solving speed. As shown in FIG. 10, the solver to which the data processing method provided in this application is applied can increase a rate by at least 40% in the 31 real production scheduling tasks.

In another experiment, in a real production scheduling problem of three consecutive months, stability of generating a production plan by the solver to which the data processing method provided in this application is applied and stability of generating a production plan by a solver Gurobi are compared. As shown in FIG. 11, for the solver Gurobi, degeneracy occurs in a solving process in three days in the three months, a value is unstable, and the production plan cannot be generated. However, the solver to which the data processing method provided in this application is applied can stably generate the production plan within two months.

The foregoing describes in detail the procedure of the data processing method provided in this application. The following describes, based on the procedure of the data processing method, a data processing apparatus provided in this application. The data processing apparatus may be configured to perform method steps in FIG. 2 to FIG. 6.

FIG. 12 is a schematic diagram of a structure of a service data processing apparatus according to this application.

The service data processing apparatus includes:

an obtaining module 1201, configured to obtain a target function and a constraint condition, where the target function indicates a solving target of a service problem, the constraint condition indicates a restriction condition of the service problem, the constraint condition includes a constraint relationship between a plurality of variables, and the target function includes at least one variable of the plurality of variables;

a base variable selection module 1202, configured to: select the at least one variable from the plurality of variables as an initial variable in a base variable group, and use a variable in the plurality of variables other than the variable included in the base variable group as an initial variable in a non-base variable group;

a sorting module 1203, configured to sort optimized values of variables in the non-base variable group, to obtain a maximum heap structure, where a first node in the maximum heap structure stores an identifier of a first variable and an optimized value of the first variable, the first node is any node in the maximum heap structure, the first variable is any variable in the non-base variable group, and the optimized value of the first variable indicates an optimization rate of the target function when a value of the first variable changes;

an update module 1204, configured to update the non-base variable group and the base variable group based on a first target variable, where the first target variable is a variable corresponding to an identifier stored by a second node in the maximum heap structure, and the second node meets a first condition; and

a solving module 1205, configured to obtain the solving target of the service problem based on a variable in an updated base variable group and the constraint condition.

In a possible implementation, the first condition includes that the second node is a root node in the maximum heap structure.

In a possible implementation, the first condition includes that the second node is a root node in the maximum heap structure when a first difference is greater than a first threshold, the first difference is a difference value between a largest optimized value in the maximum heap structure and a $K^{th}$ largest optimized value in the maximum heap structure, and K is a positive integer greater than 1.

In a possible implementation, the first condition includes that, when a first difference is less than or equal to a first threshold, the second node is a node that stores a target identifier in the maximum heap structure, and an optimized value of a variable corresponding to the target identifier is one of first K largest optimized values in the maximum heap structure.

In a possible implementation, the target identifier is an identifier in K identifiers that is stored by a root node in the maximum heap structure for a smallest quantity of times, and optimized values of variables corresponding to the K identifiers are the first K largest optimized values in the maximum heap structure.

In a possible implementation, the update module 1204 is specifically configured to exchange the first target variable with a second target variable in the base variable group.

In a possible implementation, the update module 1204 is further configured to update the maximum heap structure based on the second target variable.

In a possible implementation, the update module 1204 is further configured to iteratively update the base variable group, the non-base variable group, and the maximum heap structure for a plurality of times until a stop condition is met.

In a possible implementation, the stop condition includes that an optimized value stored by the root node in the maximum heap structure is less than a second threshold.

In a possible implementation, the stop condition includes that a quantity of iterative updates reaches a third threshold.

It should be noted that a name of a module is not specifically limited in this embodiment of this application. For example, the base variable selection module 1202, the update module 1204, and the solving module 1205 each may also be referred to as a processing module.

In addition, it should be noted that content such as information exchange and an execution process between the modules/units in the service data processing apparatus is based on a same concept as the method embodiments corresponding to FIG. 2 to FIG. 6 in this application. For specific content, refer to the descriptions in the foregoing method embodiments in this application. Details are not described herein again.

Refer to FIG. 13. This application further provides a production plan generation apparatus, and the production plan generation apparatus includes:

- an obtaining module 1301, configured to obtain a target function and a constraint condition, where the target function indicates to solve a production plan of a production product, the constraint condition indicates a restriction condition of the production plan, the constraint condition includes a constraint relationship between a plurality of variables, and the target function includes at least one variable of the plurality of variables;
- a base variable selection module 1302, configured to: select the at least one variable from the plurality of variables as an initial variable in a base variable group, and use a variable in the plurality of variables other than the variable included in the base variable group as an initial variable in a non-base variable group;
- a sorting module 1303, configured to sort optimized values of variables in the non-base variable group, to obtain a maximum heap structure, where a first node in the maximum heap structure stores an identifier of a first variable and an optimized value of the first variable, the first node is any node in the maximum heap structure, the first variable is any variable in the non-base variable group, the optimized value of the first variable indicates an optimization rate of the target function when a value of the first variable changes, and the optimization rate of the target function indicates a reduction rate of generation plan costs;
- an update module 1304, configured to update the non-base variable group and the base variable group based on a first target variable, where the first target variable is a variable corresponding to an identifier stored by a second node in the maximum heap structure, and the second node meets a first condition; and
- a solving module 1305, configured to obtain a solving target of a service problem based on a variable in an updated base variable group and the constraint condition.

In a possible implementation, the first condition includes that the second node is a root node in the maximum heap structure.

In a possible implementation, the first condition includes that the second node is a root node in the maximum heap structure when a first difference is greater than a first threshold, the first difference is a difference value between a largest optimized value in the maximum heap structure and a $K^{th}$ largest optimized value in the maximum heap structure, and K is a positive integer greater than 1.

In a possible implementation, the first condition includes that, when a first difference is less than or equal to a first threshold, the second node is a node that stores a target identifier in the maximum heap structure, and an optimized value of a variable corresponding to the target identifier is one of first K largest optimized values in the maximum heap structure.

In a possible implementation, the target identifier is an identifier in K identifiers that is stored by a root node in the maximum heap structure for a smallest quantity of times, and optimized values of variables corresponding to the K identifiers are the first K largest optimized values in the maximum heap structure.

In a possible implementation, the update module 1304 is specifically configured to exchange the first target variable with a second target variable in the base variable group.

In a possible implementation, the update module 1304 is further configured to update the maximum heap structure based on the second target variable.

In a possible implementation, the update module 1304 is further configured to iteratively update the base variable group, the non-base variable group, and the maximum heap structure for a plurality of times until a stop condition is met.

In a possible implementation, the stop condition includes that an optimized value stored by the root node in the maximum heap structure is less than a second threshold.

In a possible implementation, the stop condition includes that a quantity of iterative updates reaches a third threshold.

It should be noted that a name of a module is not specifically limited in this embodiment of this application. For example, the base variable selection module 1302, the update module 1304, and the solving module 1305 each may also be referred to as a processing module.

In addition, it should be noted that content such as information exchange and an execution process between the modules/units in the service data processing apparatus is based on a same concept as the method embodiments corresponding to FIG. 7 and FIG. 8 in this application. For specific content, refer to the descriptions in the foregoing method embodiments in this application. Details are not described herein again.

An embodiment of this application further provides a service data processing apparatus. FIG. 14 is a schematic diagram of a structure of the service data processing apparatus according to this embodiment of this application. The service data processing apparatus described in the embodiment corresponding to FIG. 12 may be deployed on the service data processing apparatus 1400, and is configured to implement functions of the service data processing apparatus in embodiments corresponding to FIG. 2 to FIG. 6. Specifically, the service data processing apparatus 1400 may have a large difference due to different configurations or performance, and may include one or more central processing units CPUs 1422 (for example, one or more processors) and a memory 1432, and one or more storage media 1430 (for example, one or more mass storage devices) for storing an application 1442 or data 1444.

The memory 1432 and the storage medium 1430 may be temporary storage or permanent storage. In an embodiment, the memory 1432 is a random access memory (random access memory, RAM), and may directly exchange data with the central processing unit 1422, is configured to load the data 1444 and the application 1442 and/or an operating system 1441 for the central processing unit 1422 to directly run and use, and is usually used as a temporary data storage medium of the operating system or another running program. A program stored in the storage medium 1430 may include one or more modules (not shown in FIG. 14), and each module may include a series of instruction operations on the data processing apparatus.

Further, the central processing unit 1422 may be configured to communicate with the storage medium 1430, and perform, on the data processing apparatus 1400, the series of instruction operations in the storage medium 1430. In a possible implementation, the storage medium 1430 stores program instructions and data corresponding to the method steps shown in any one of embodiments in FIG. 3 to FIG. 13. In a possible implementation, the memory 1432 and the storage medium 1430 are configured to store an identifier stored by a root node in a maximum heap structure. The central processing unit 1422 may obtain, based on data stored in the memory 1432 and the storage medium 1430, a quantity of times that each identifier is stored by the root node. In a possible implementation, the central processing unit 1422 obtains an identifier stored by the root node in the maximum heap structure, or may directly collect statistics on a quantity of times that each identifier is stored by the root node. A manner of collecting statistics on the quantity of times that each identifier is stored by the root node is not limited in embodiments of this application.

The service data processing apparatus 1400 may further include one or more power supplies 1426, one or more wired or wireless network interfaces 1450, one or more input/output interfaces 1458, and/or one or more operating systems 1441, such as Windows ServerTM, Mac OS XTM, UnixTM, LinuxTM, and FreeBSDTM.

In a possible implementation, the central processing unit 1422 is configured to perform method steps performed by the service data processing apparatus shown in any one of embodiments in FIG. 2 to FIG. 6. There may be one or more central processing units.

An embodiment of this application further provides a service data processing apparatus. The data processing apparatus may also be referred to as a digital processing chip or a chip. The chip includes a processing unit and a communication interface. The processing unit may obtain program instructions through the communication interface, and when the program instructions are executed by the processing unit, the processing unit is configured to perform the method steps performed by the service data processing apparatus in any one of the foregoing embodiments in FIG. 2 to FIG. 6.

An embodiment of this application further provides a digital processing chip. The digital processing chip integrates a circuit and one or more interfaces that are configured to implement a function of the central processing unit 1422 or the central processing unit 1422. When a memory is integrated into the digital processing chip, the digital processing chip may complete the method steps in any one or more of the foregoing embodiments. When a memory is not integrated into the digital processing chip, the digital processing chip may be connected to an external memory through a communication interface. The digital processing chip implements, based on program code stored in the external memory, the actions performed by the service data processing apparatus in the foregoing embodiments.

More specifically, when the service data processing apparatus provided in this embodiment of this application is a chip, the chip specifically includes a processing unit and a communication unit. The processing unit may be, for example, a processor, and the communication unit may be, for example, an input/output interface, a pin, or a circuit. The processing unit may execute computer-executable instructions stored in a storage unit, so that the chip in a server performs the data processing method described in embodiments shown in FIG. 2 to FIG. 6.

An embodiment of this application further provides a production plan generation apparatus. FIG. 15 is a schematic diagram of a structure of the production plan generation apparatus according to this embodiment of this application. The production plan generation apparatus described in the embodiment corresponding to FIG. 13 may be deployed on the production plan generation apparatus 1500, and is configured to implement functions of the production plan generation apparatus in embodiments corresponding to FIG. 7 and FIG. 8. Specifically, the production plan generation apparatus 1500 may have a large difference due to different configurations or performance, and may include one or more central processing units CPUs 1522 (for example, one or more processors) and a memory 1532, and one or more storage media 1530 (for example, one or more mass storage devices) for storing an application 1542 or data 1544.

The memory 1532 and the storage medium 1530 may be temporary storage or permanent storage. In an embodiment, the memory 1532 is a random access memory RAM, and may directly exchange data with the central processing unit 1522, is configured to load the data 1544 and the application 1542 and/or an operating system 1541 for the central processing unit 1522 to directly run and use, and is usually used as a temporary data storage medium of the operating system or another running program. A program stored in the storage medium 1530 may include one or more modules (not shown in FIG. 15), and each module may include a series of instruction operations on the production plan generation apparatus.

Further, the central processing unit 1522 may be configured to communicate with the storage medium 1530, and perform, on the production plan generation apparatus 1500, the series of instruction operations in the storage medium 1530. In a possible implementation, the storage medium 1530 stores program instructions and data corresponding to the method steps shown in any one of embodiments in FIG. 7 and FIG. 8. In a possible implementation, the memory 1532 and the storage medium 1530 are configured to store an identifier stored by a root node in a maximum heap structure. The central processing unit 1522 may obtain, based on data stored in the memory 1532 and the storage medium 1530, a quantity of times that each identifier is stored by the root node. In a possible implementation, the central processing unit 1522 obtains an identifier stored by the root node in the maximum heap structure, or may directly collect statistics on a quantity of times that each identifier is stored by the root node. A manner of collecting statistics on the quantity of times that each identifier is stored by the root node is not limited in embodiments of this application.

The production plan generation apparatus 1500 may further include one or more power supplies 1526, one or more wired or wireless network interfaces 1550, one or more input/output interfaces 1558, and/or one or more operating systems 1541, such as Windows ServerTM, Mac OS XTM, UnixTM, LinuxTM, and FreeBSDTM.

In a possible implementation, the central processing unit 1522 is configured to perform the method steps performed by the production plan generation apparatus shown in any one of the foregoing embodiments in FIG. 7 and FIG. 8.

An embodiment of this application further provides a production plan generation apparatus. The production plan generation apparatus may also be referred to as a digital processing chip or a chip. The chip includes a processing unit and a communication interface. The processing unit may obtain program instructions through the communication interface. The program instructions are executed by the processing unit. The processing unit is configured to perform the method steps performed by the production plan generation apparatus shown in any one of embodiments in FIG. 7 and FIG. 8.

An embodiment of this application further provides a digital processing chip. A circuit and one or more interfaces that are configured to implement functions of the processor 1501 or the processor 1501 are integrated into the digital processing chip. When a memory is integrated into the digital processing chip, the digital processing chip may complete the method steps in any one or more of the foregoing embodiments. When a memory is not integrated into the digital processing chip, the digital processing chip may be connected to an external memory through a communication interface. The digital processing chip implements, based on program code stored in the external memory, the actions performed by the production plan generation apparatus in the foregoing embodiments.

More specifically, when the production plan generation apparatus provided in embodiments of this application is a chip, the chip specifically includes a processing unit and a communication unit. The processing unit may be, for example, a processor, and the communication unit may be, for example, an input/output interface, a pin, or a circuit. The processing unit may execute computer-executable instructions stored in a storage unit, so that a chip in a server performs the production plan generation method described in embodiments shown in FIG. 7 and FIG. 8.

Optionally, the storage unit is a storage unit in the chip, for example, a register or a cache. The storage unit may alternatively be a storage unit that is in a wireless access device and that is outside the chip, for example, a read-only memory (read-only memory, ROM) or another type of static storage device that can store static information and instructions, or a random access memory RAM.

Specifically, the processing unit or the processor may be a central processing unit, a network processor (neural-network processing unit, NPU), a graphics processing unit (graphics processing unit, GPU), a digital signal processor (digital signal processor, DSP), an application-specific integrated circuit (application-specific integrated circuit, ASIC), a field programmable gate array (field programmable gate array, FPGA), another programmable logic device, a discrete gate, a transistor logic device, a discrete hardware component, or the like. A general-purpose processor may be a microprocessor or any regular processor or the like.

The processor mentioned anywhere above may be a general-purpose central processing unit, a microprocessor, an ASIC, or one or more integrated circuits configured to control program execution of the methods in FIG. 2 to FIG. 9.

An embodiment of this application further provides a computer-readable storage medium. The computer-readable storage medium stores a program. When the program is run on a computer, the computer is enabled to perform the steps in the methods described in embodiments shown in FIG. 2 to FIG. 9.

An embodiment of this application further provides a computer program product. When the computer program product runs on a computer, the computer is enabled to perform steps performed by the data processing apparatus or the production plan generation apparatus in the methods described in embodiments shown in FIG. 3 to FIG. 14.

In addition, it should be noted that the described apparatus embodiment is merely an example. The units described as separate parts may or may not be physically separate, and parts displayed as units may or may not be physical units, may be located in one position, or may be distributed on a plurality of network units. Some or all the modules may be selected based on actual requirements to achieve the objectives of the solutions of embodiments. In addition, in the accompanying drawings of the apparatus embodiments provided by this application, connection relationships between modules indicate that the modules have communication connections with each other, which may be specifically implemented as one or more communication buses or signal cables.

Based on the description of the foregoing implementations, a person skilled in the art may clearly understand that this application may be implemented by software in addition to necessary universal hardware, or by dedicated hardware, including a dedicated integrated circuit, a dedicated CPU, a dedicated memory, a dedicated component, and the like. Generally, any functions that can be performed by a computer program can be easily implemented by using corresponding hardware. Moreover, a specific hardware structure used to achieve a same function may be in various forms, for example, in a form of an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The computer software product is stored in a readable storage medium, like a floppy disk, a USB flash drive, a removable hard disk, a read-only memory ROM, a random access memory RAM, a magnetic disk, or an optical disc of a computer, and includes several instructions for instructing a computer device (which may be a personal computer, a server, a network device, or the like) to perform the methods described in embodiments of this application.

All or some of the foregoing embodiments may be implemented by using software, hardware, firmware, or any combination thereof. When software is used to implement embodiments, all or a part of embodiments may be implemented in a form of a computer program product.

The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid state disk, SSD)), or the like.

In the specification, claims, and accompanying drawings of this application, the terms "first", "second", "third", "fourth", and the like (if existent) are intended to distinguish between similar objects but do not necessarily indicate a specific order or sequence. It should be understood that the data termed in such a way are interchangeable in proper circumstances, so that embodiments described herein can be implemented in other orders than the order illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

Finally, it should be noted that the foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A service data processing method, comprising:

   obtaining a target function and a constraint condition, wherein the target function indicates a solving target of a service problem, the constraint condition indicates a restriction condition of the service problem, the constraint condition comprises a constraint relationship between a plurality of variables, and the target function comprises at least one variable of the plurality of variables;
   selecting the at least one variable from the plurality of variables as an initial variable in a base variable group, and using a variable in the plurality of variables other than the variable comprised in the base variable group as an initial variable in a non-base variable group;
   sorting optimized values of variables in the non-base variable group, to obtain a maximum heap structure, wherein a first node in the maximum heap structure stores an identifier of a first variable and an optimized value of the first variable, the first node is any node in the maximum heap structure, the first variable is any variable in the non-base variable group, and the optimized value of the first variable indicates an optimization rate of the target function when a value of the first variable changes;
   updating the non-base variable group and the base variable group based on a first target variable, wherein the first target variable is a variable corresponding to an identifier stored by a second node in the maximum heap structure, and the second node meets a first condition; and
   obtaining the solving target of the service problem based on a variable in an updated base variable group and the constraint condition.

2. The method according to claim 1, wherein the first condition comprises that the second node is a root node in the maximum heap structure.

3. The method according to claim 1, wherein the first condition comprises that the second node is a root node in the maximum heap structure when a first difference is greater than a first threshold, the first difference is a difference value between a largest optimized value and a $K^{th}$ largest optimized value in the maximum heap structure, and K is a positive integer greater than 1.

4. The method according to claim 1, wherein the first condition comprises that, when a first difference is less than or equal to a first threshold, the second node is a node that stores a target identifier in the maximum heap structure, the first difference is a difference value between a largest optimized value and a $K^{th}$ largest optimized value in the maximum heap structure, K is a positive integer greater than 1, and an optimized value of a variable corresponding to the target identifier is one of first K largest optimized values in the maximum heap structure.

5. The method according to claim 4, wherein the target identifier is an identifier in K identifiers that is stored by a root node in the maximum heap structure for a smallest quantity of times, and optimized values of variables corresponding to the K identifiers are the first K largest optimized values in the maximum heap structure.

6. The method according to any one of claims 1 to 5, wherein the updating the non-base variable group and the base variable group based on a first target variable comprises:
   exchanging the first target variable with a second target variable in the base variable group.

7. The method according to claim 6, wherein the method further comprises:
   updating the maximum heap structure based on the second target variable.

8. The method according to claim 7, wherein the method further comprises:
   iteratively updating the base variable group, the non-base variable group, and the maximum heap structure for a plurality of times until a stop condition is met.

9. The method according to claim 8, wherein the stop condition comprises that an optimized value stored by the root node in the maximum heap structure is less than a second threshold.

10. The method according to claim 8, wherein the stop condition comprises that a quantity of iterative updates reaches a third threshold.

11. A production plan generation method, comprising:

obtaining a target function and a constraint condition, wherein the target function indicates a solving target of a product production plan, the constraint condition indicates a restriction condition of the production plan, the constraint condition comprises a constraint relationship between a plurality of variables related to production, and the target function comprises at least one variable of the plurality of variables;
selecting the at least one variable from the plurality of variables as an initial variable in a base variable group, and using a variable in the plurality of variables other than the variable comprised in the base variable group as an initial variable in a non-base variable group;
sorting optimized values of variables in the non-base variable group, to obtain a maximum heap structure, wherein a first node in the maximum heap structure stores an identifier of a first variable and an optimized value of the first variable, the first node is any node in the maximum heap structure, the first variable is any variable in the non-base variable group, and the optimized value of the first variable indicates an optimization rate of the target function when a value of the first variable changes;
updating the non-base variable group and the base variable group based on a first target variable, wherein the first target variable is a variable corresponding to an identifier stored by a second node in the maximum heap structure, and the second node meets a first condition; and
obtaining the production plan based on a variable in an updated base variable group and the constraint condition.

**12.** The method according to claim 11, wherein the first condition comprises that the second node is a root node in the maximum heap structure.

**13.** The method according to claim 11, wherein the first condition comprises that the second node is a root node in the maximum heap structure when a first difference is greater than a first threshold, the first difference is a difference value between a largest optimized value and a $K^{th}$ largest optimized value in the maximum heap structure, and K is a positive integer greater than 1.

**14.** The method according to claim 11, wherein the first condition comprises that, when a first difference is less than or equal to a first threshold, the second node is a node that stores a target identifier in the maximum heap structure, the first difference is a difference value between a largest optimized value and a $K^{th}$ largest optimized value in the maximum heap structure, K is a positive integer greater than 1, and an optimized value of a variable corresponding to the target identifier is one of first K largest optimized values in the maximum heap structure.

**15.** The method according to claim 14, wherein the target identifier is an identifier in K identifiers that is stored by a root node in the maximum heap structure for a smallest quantity of times, and optimized values of variables corresponding to the K identifiers are the first K largest optimized values in the maximum heap structure.

**16.** The method according to any one of claims 11 to 15, wherein the updating the non-base variable group and the base variable group based on a first target variable comprises:
exchanging the first target variable with a second target variable in the base variable group.

**17.** The method according to claim 16, wherein the method further comprises:
updating the maximum heap structure based on the second target variable.

**18.** The method according to claim 17, wherein the method further comprises:
iteratively updating the base variable group, the non-base variable group, and the maximum heap structure for a plurality of times until a stop condition is met.

**19.** The method according to claim 18, wherein the stop condition comprises that an optimized value stored by the root node in the maximum heap structure is less than a second threshold.

**20.** The method according to claim 18, wherein the stop condition comprises that a quantity of iterative updates reaches a third threshold.

**21.** A service data processing apparatus, comprising:

an obtaining module, configured to obtain a target function and a constraint condition, wherein the target function indicates a solving target of a service problem, the constraint condition indicates a restriction condition of the service problem, the constraint condition comprises a constraint relationship between a plurality of variables, and the target function comprises at least one variable of the plurality of variables;

a base variable selection module, configured to: select the at least one variable from the plurality of variables as an initial variable in a base variable group, and use a variable in the plurality of variables other than the variable comprised in the base variable group as an initial variable in a non-base variable group;
a sorting module, configured to sort optimized values of variables in the non-base variable group, to obtain a maximum heap structure, wherein a first node in the maximum heap structure stores an identifier of a first variable and an optimized value of the first variable, the first node is any node in the maximum heap structure, the first variable is any variable in the non-base variable group, and the optimized value of the first variable indicates an optimization rate of the target function when a value of the first variable changes;
an update module, configured to update the non-base variable group and the base variable group based on a first target variable, wherein the first target variable is a variable corresponding to an identifier stored by a second node in the maximum heap structure, and the second node meets a first condition; and
a solving module, configured to obtain the solving target of the service problem based on a variable in an updated base variable group and the constraint condition.

**22.** The apparatus according to claim 21, wherein the first condition comprises that the second node is a root node in the maximum heap structure.

**23.** The apparatus according to claim 21, wherein the first condition comprises that the second node is a root node in the maximum heap structure when a first difference is greater than a first threshold, the first difference is a difference value between a largest optimized value and a $K^{th}$ largest optimized value in the maximum heap structure, and K is a positive integer greater than 1.

**24.** The apparatus according to claim 21, wherein the first condition comprises that, when a first difference is less than or equal to a first threshold, the second node is a node that stores a target identifier in the maximum heap structure, the first difference is a difference value between a largest optimized value and a $K^{th}$ largest optimized value in the maximum heap structure, K is a positive integer greater than 1, and an optimized value of a variable corresponding to the target identifier is one of first K largest optimized values in the maximum heap structure.

**25.** The apparatus according to claim 24, wherein the target identifier is an identifier in K identifiers that is stored by a root node in the maximum heap structure for a smallest quantity of times, and optimized values of variables corresponding to the K identifiers are the first K largest optimized values in the maximum heap structure.

**26.** The apparatus according to any one of claims 21 to 25, wherein the update module is specifically configured to: exchange the first target variable with a second target variable in the base variable group.

**27.** The apparatus according to claim 26, wherein the update module is further configured to:
update the maximum heap structure based on the second target variable.

**28.** The apparatus according to claim 27, wherein the update module is further configured to:
iteratively update the base variable group, the non-base variable group, and the maximum heap structure for a plurality of times until a stop condition is met.

**29.** The apparatus according to claim 28, wherein the stop condition comprises that an optimized value stored by the root node in the maximum heap structure is less than a second threshold.

**30.** The apparatus according to claim 28, wherein the stop condition comprises that a quantity of iterative updates reaches a third threshold.

**31.** A production plan generation apparatus, comprising:

an obtaining module, configured to obtain a target function and a constraint condition, wherein the target function indicates a solving target of a product production plan, the constraint condition indicates a restriction condition of the production plan, the constraint condition comprises a constraint relationship between a plurality of variables related to production, and the target function comprises at least one variable of the plurality of variables;
a base variable selection module, configured to: select the at least one variable from the plurality of variables as an initial variable in a base variable group, and use a variable in the plurality of variables other than the variable comprised in the base variable group as an initial variable in a non-base variable group;
a sorting module, configured to sort optimized values of variables in the non-base variable group, to obtain a maximum heap structure, wherein a first node in the maximum heap structure stores an identifier of a first variable and an optimized value of the first variable, the first node is any node in the maximum heap structure, the first variable is any variable in the non-base variable group, the optimized value of the first variable indicates an optimization rate of the target function when a value of the first variable changes, and the optimization rate of the target function indicates a reduction rate of generation plan costs;
an update module, configured to update the non-base variable group and the base variable group based on a first target variable, wherein the first target variable is a variable corresponding to an identifier stored by a second node in the maximum heap structure, and the second node meets a first condition; and
a solving module, configured to obtain the solving target of the service problem based on a variable in an updated base variable group and the constraint condition.

**32.** A service data processing apparatus, comprising one or more processors, wherein the one or more processors are coupled to a memory, the memory stores a program, and when program instructions stored in the memory are executed by the one or more processors, the method according to any one of claims 1 to 10 is implemented.

**33.** A production plan generation apparatus, comprising one or more processors, wherein the one or more processors are coupled to a memory, the memory stores a program, and when program instructions stored in the memory are executed by the one or more processors, the method according to any one of claims 11 to 20 is implemented.

**34.** A computer-readable storage medium, comprising a program, wherein when the program is executed by a processing unit, the method according to any one of claims 1 to 20 is performed.

**35.** A computer program product, comprising computer programs/instructions, wherein when the computer programs/instructions are executed by a processor, steps of the methods according to any one of claims 1 to 20 are implemented.

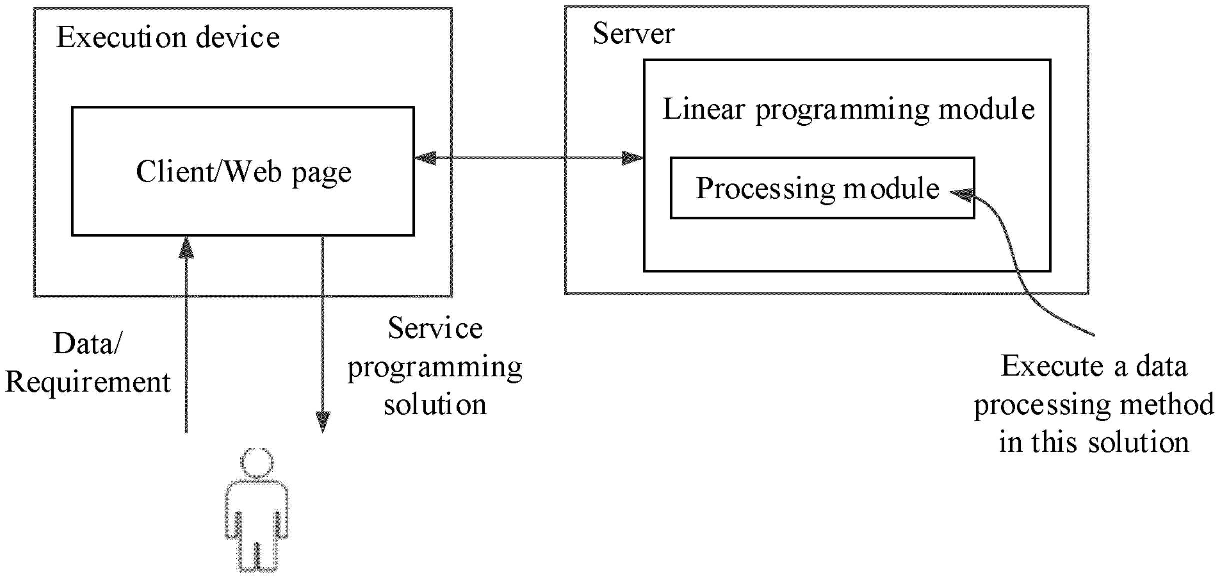
Execution device
Client/Web page
Server
Linear programming module
Processing module
Data/
Requirement
Service
programming
solution
Execute a data
processing method
in this solution

FIG. 1

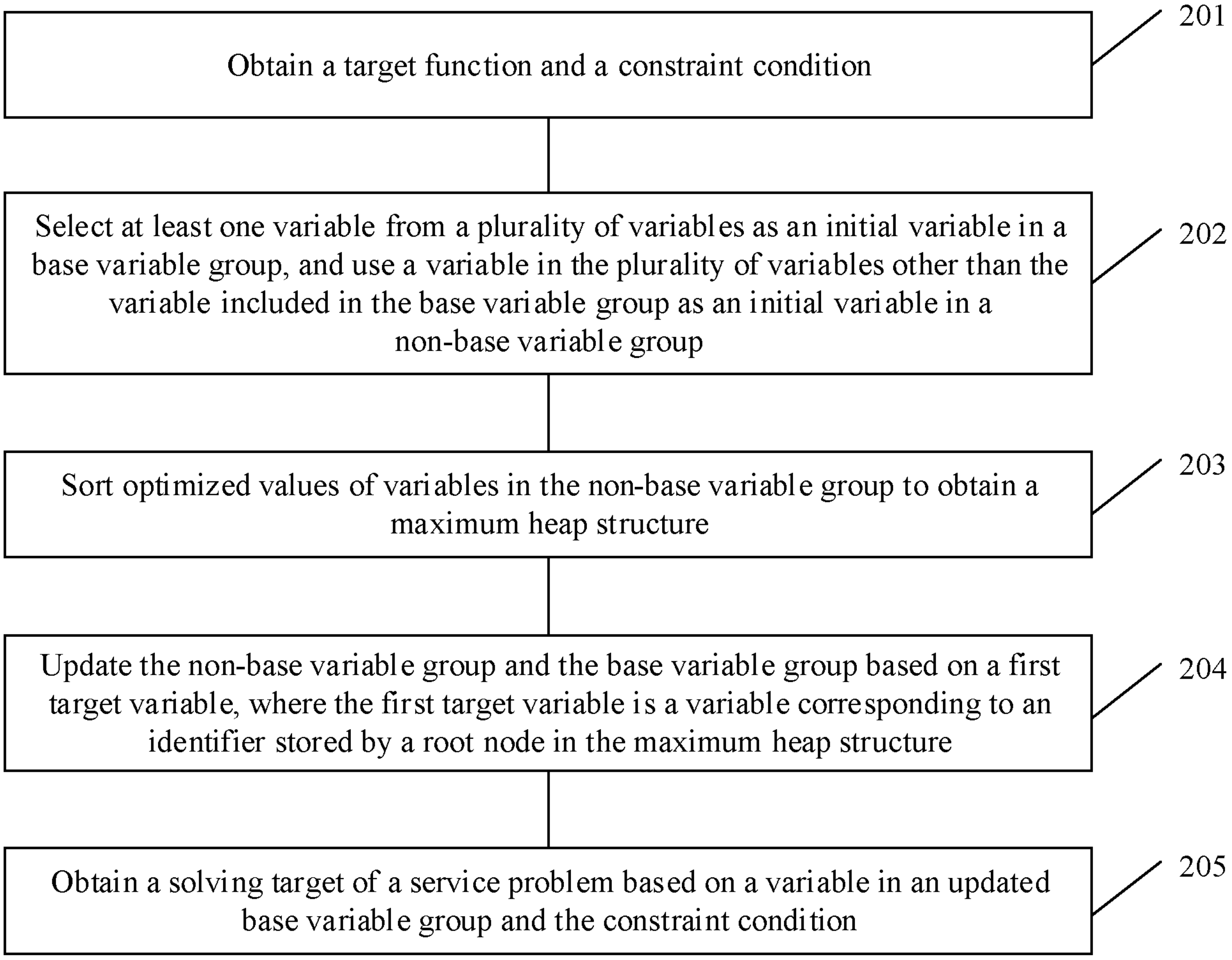
Obtain a target function and a constraint condition
201
Select at least one variable from a plurality of variables as an initial variable in a base variable group, and use a variable in the plurality of variables other than the variable included in the base variable group as an initial variable in a non-base variable group
202
Sort optimized values of variables in the non-base variable group to obtain a maximum heap structure
203
Update the non-base variable group and the base variable group based on a first target variable, where the first target variable is a variable corresponding to an identifier stored by a root node in the maximum heap structure
204
Obtain a solving target of a service problem based on a variable in an updated base variable group and the constraint condition
205

FIG. 2

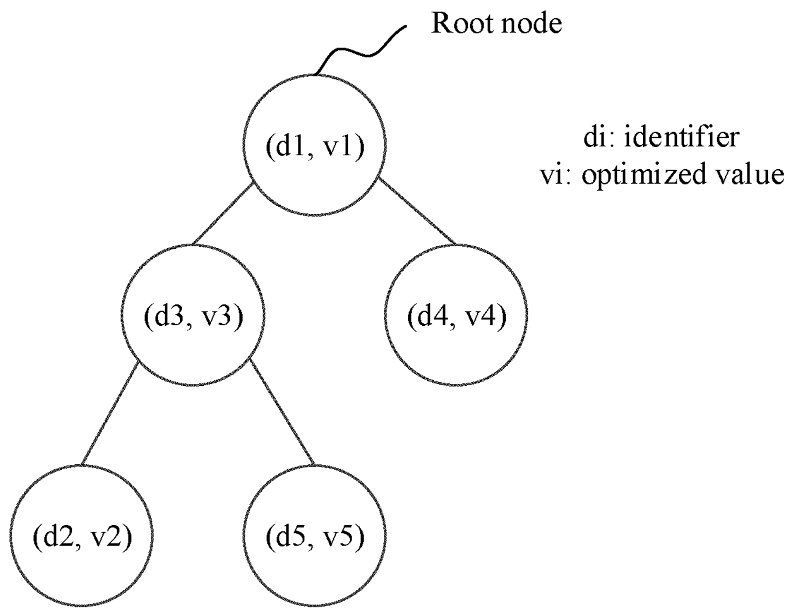
Root node
(d1, v1)
di: identifier
vi: optimized value
(d3, v3)
(d4, v4)
(d2, v2)
(d5, v5)

FIG. 3

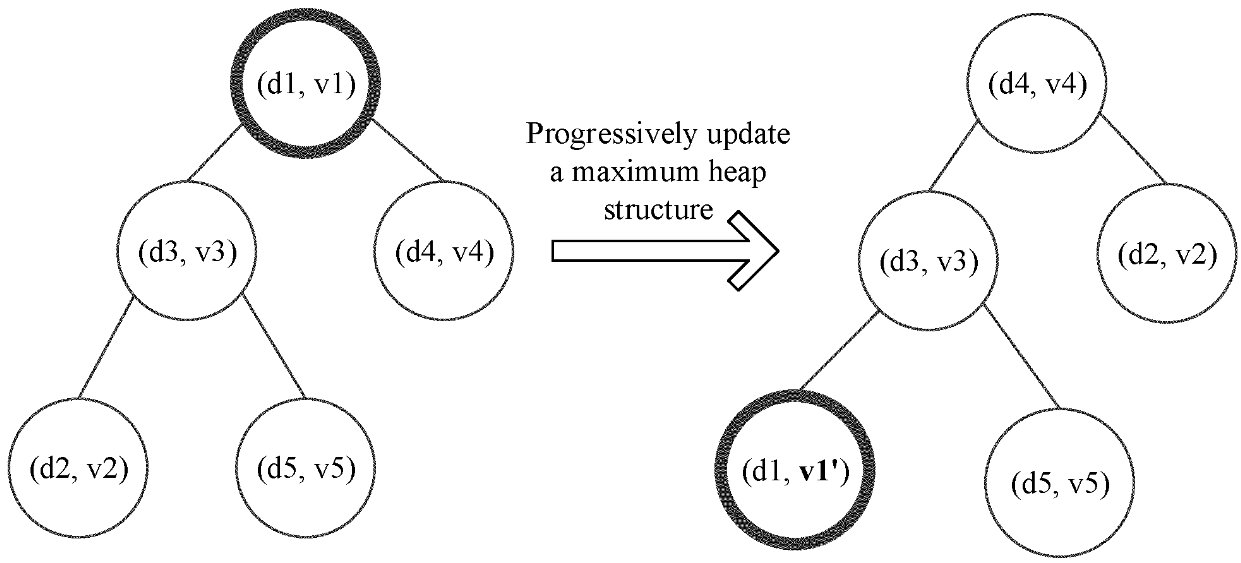
(d1, v1)
(d3, v3)
(d4, v4)
(d2, v2)
(d5, v5)
Progressively update a maximum heap structure
(d4, v4)
(d3, v3)
(d2, v2)
(d1, v1')
(d5, v5)

FIG. 4

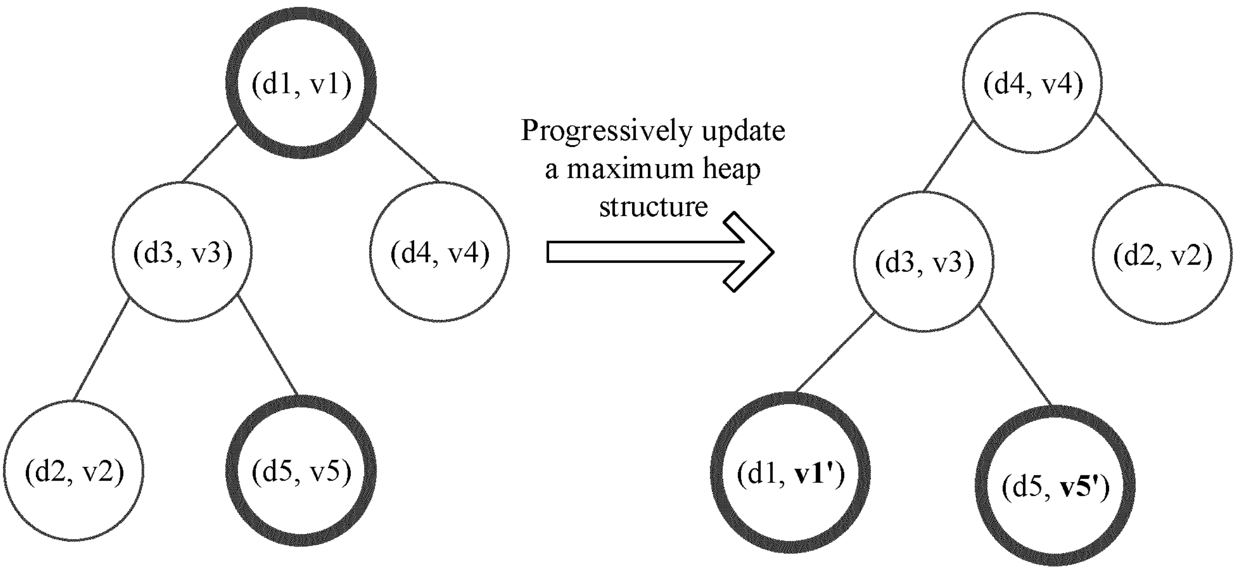
(d1, v1)
(d3, v3)
(d4, v4)
(d2, v2)
(d5, v5)
Progressively update a maximum heap structure
(d4, v4)
(d3, v3)
(d2, v2)
(d1, v1')
(d5, v5')

FIG. 5

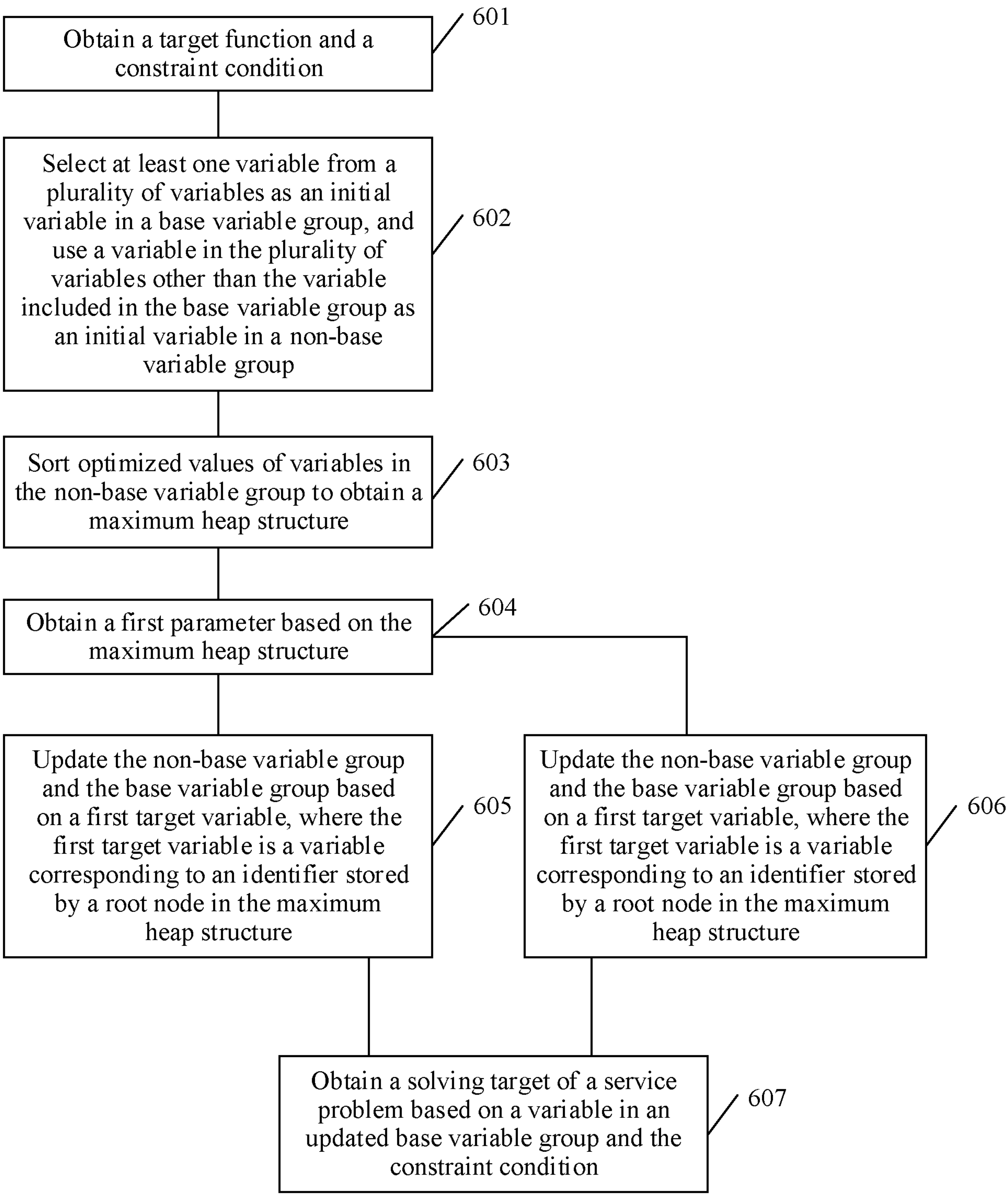
Obtain a target function and a constraint condition
601
Select at least one variable from a plurality of variables as an initial variable in a base variable group, and use a variable in the plurality of variables other than the variable included in the base variable group as an initial variable in a non-base variable group
602
Sort optimized values of variables in the non-base variable group to obtain a maximum heap structure
603
Obtain a first parameter based on the maximum heap structure
604
Update the non-base variable group and the base variable group based on a first target variable, where the first target variable is a variable corresponding to an identifier stored by a root node in the maximum heap structure
605
Update the non-base variable group and the base variable group based on a first target variable, where the first target variable is a variable corresponding to an identifier stored by a root node in the maximum heap structure
606
Obtain a solving target of a service problem based on a variable in an updated base variable group and the constraint condition
607

FIG. 6

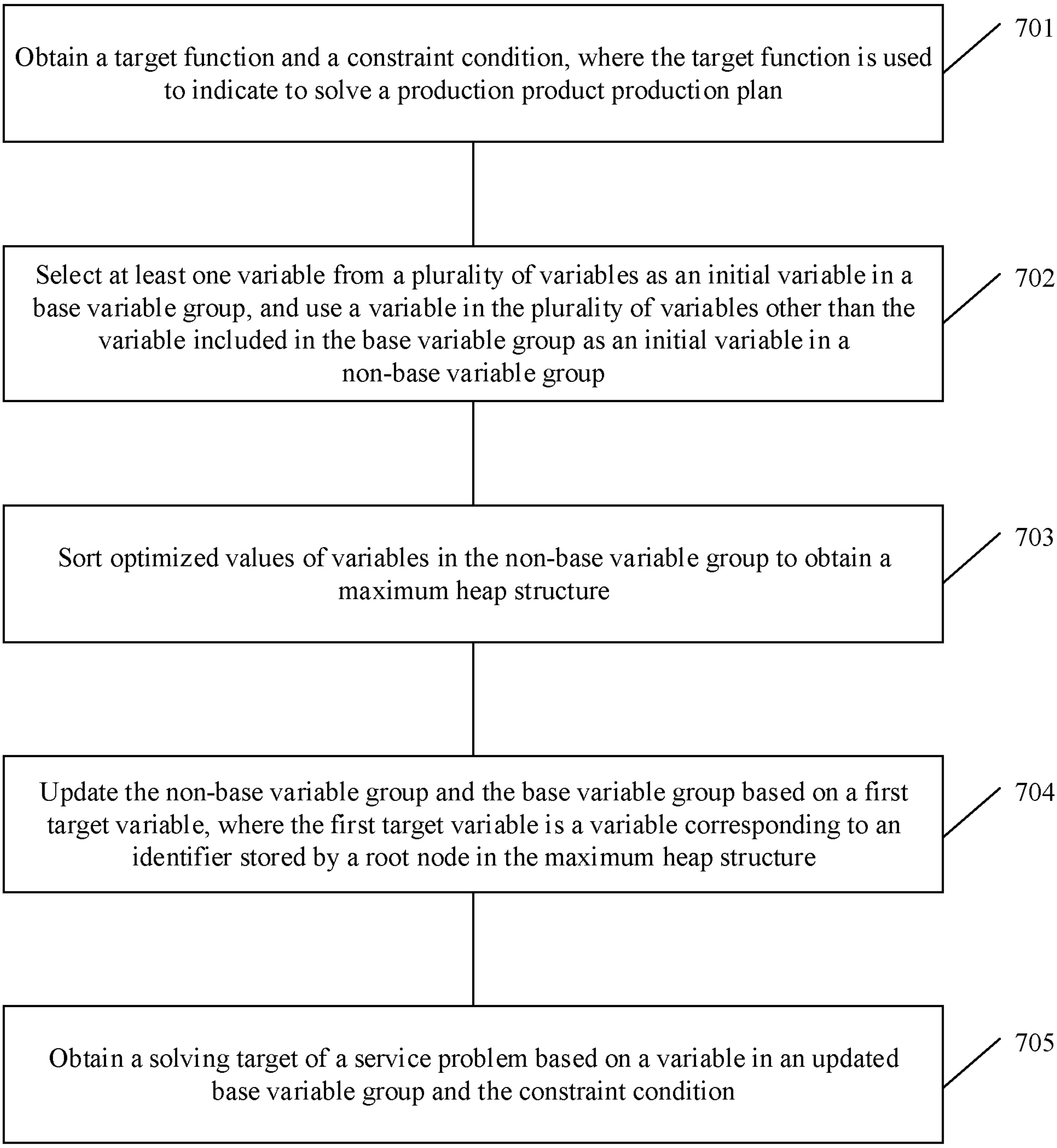
Obtain a target function and a constraint condition, where the target function is used to indicate to solve a production product production plan
701
Select at least one variable from a plurality of variables as an initial variable in a base variable group, and use a variable in the plurality of variables other than the variable included in the base variable group as an initial variable in a non-base variable group
702
Sort optimized values of variables in the non-base variable group to obtain a maximum heap structure
703
Update the non-base variable group and the base variable group based on a first target variable, where the first target variable is a variable corresponding to an identifier stored by a root node in the maximum heap structure
704
Obtain a solving target of a service problem based on a variable in an updated base variable group and the constraint condition
705

FIG. 7

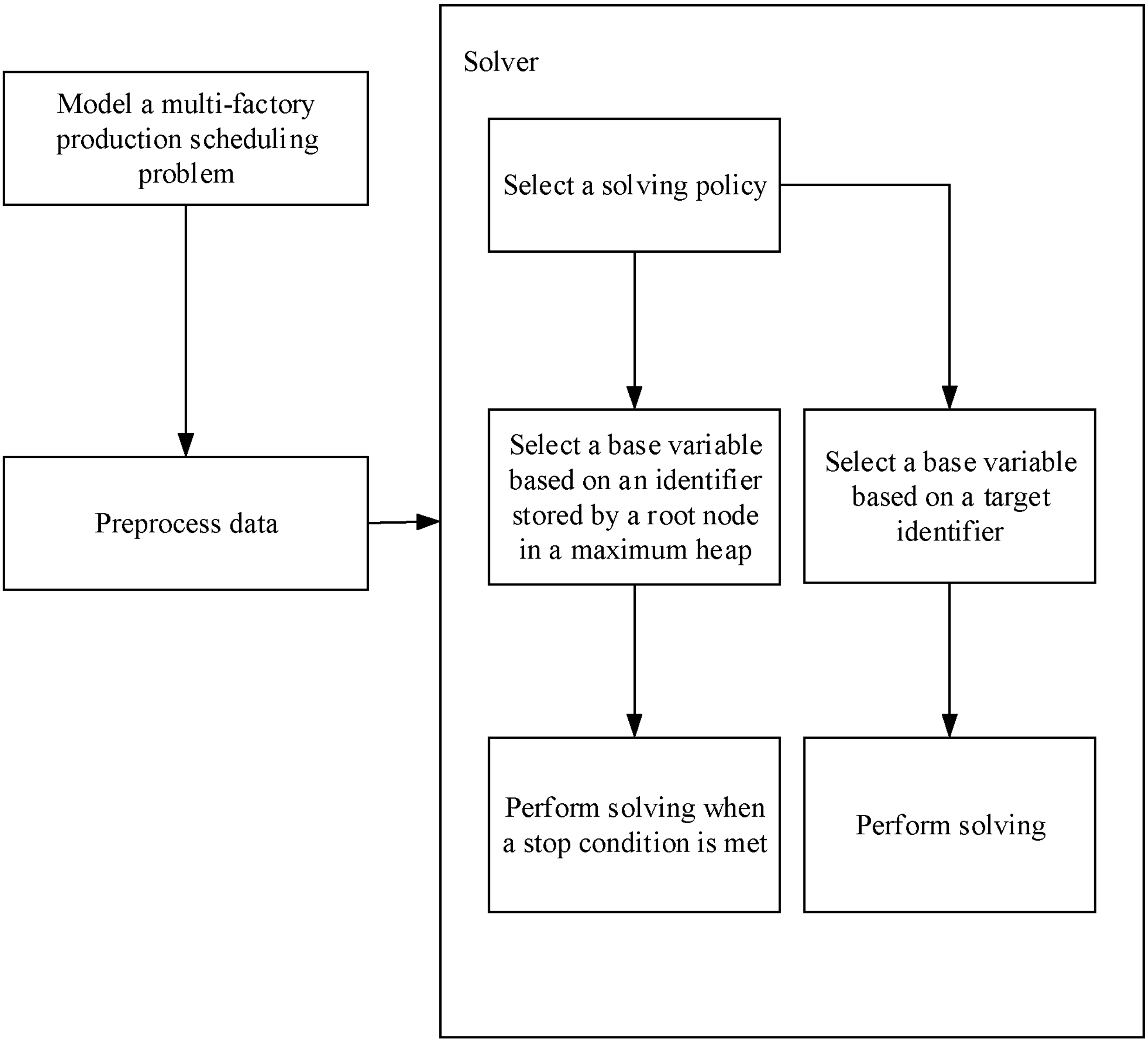
Solver
Model a multi-factory production scheduling problem
Preprocess data
Select a solving policy
Select a base variable based on an identifier stored by a root node in a maximum heap
Select a base variable based on a target identifier
Perform solving when a stop condition is met
Perform solving

FIG. 8

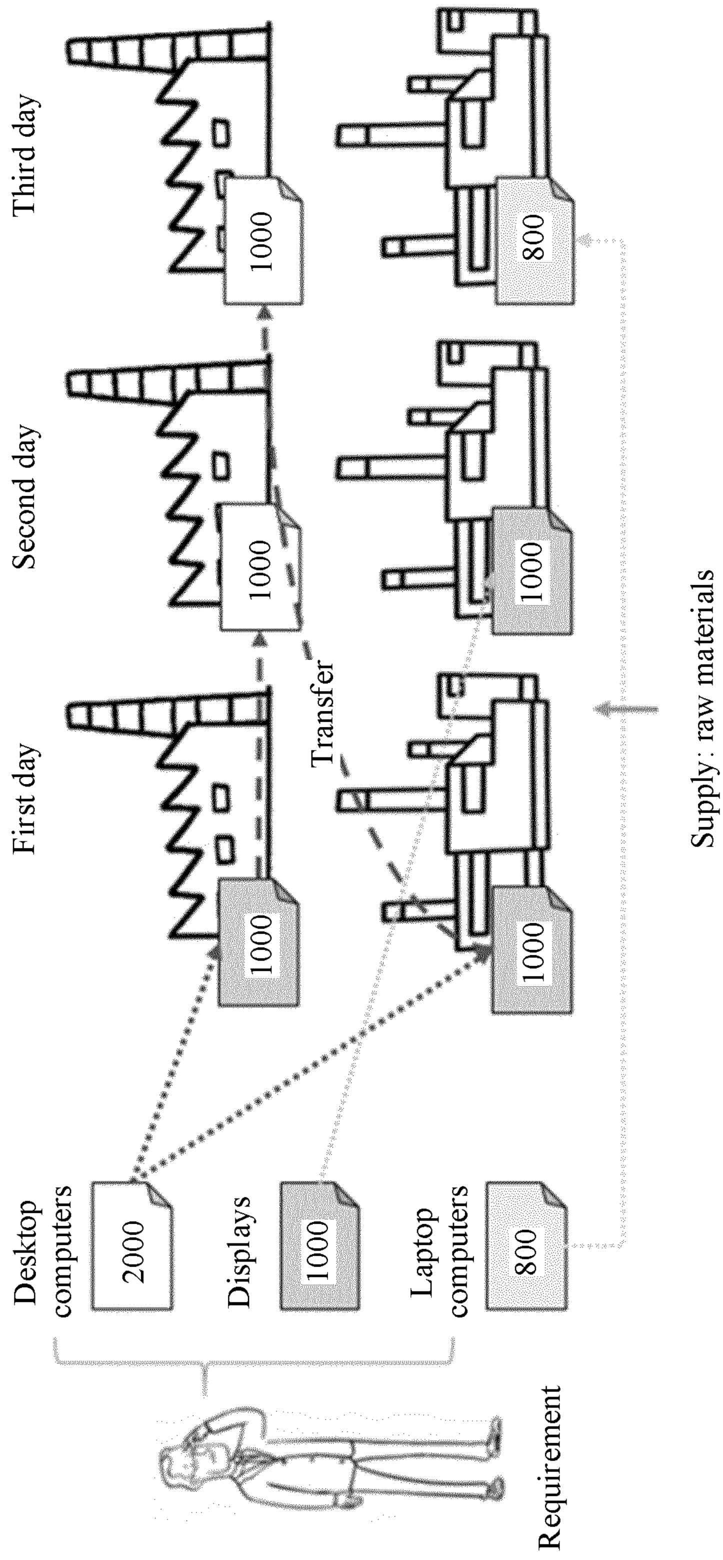
Requirement
Desktop computers
2000
Displays
1000
Laptop computers
800
First day
Second day
Third day
1000
1000
1000
1000
1000
800
Transfer
Supply: raw materials

FIG. 9

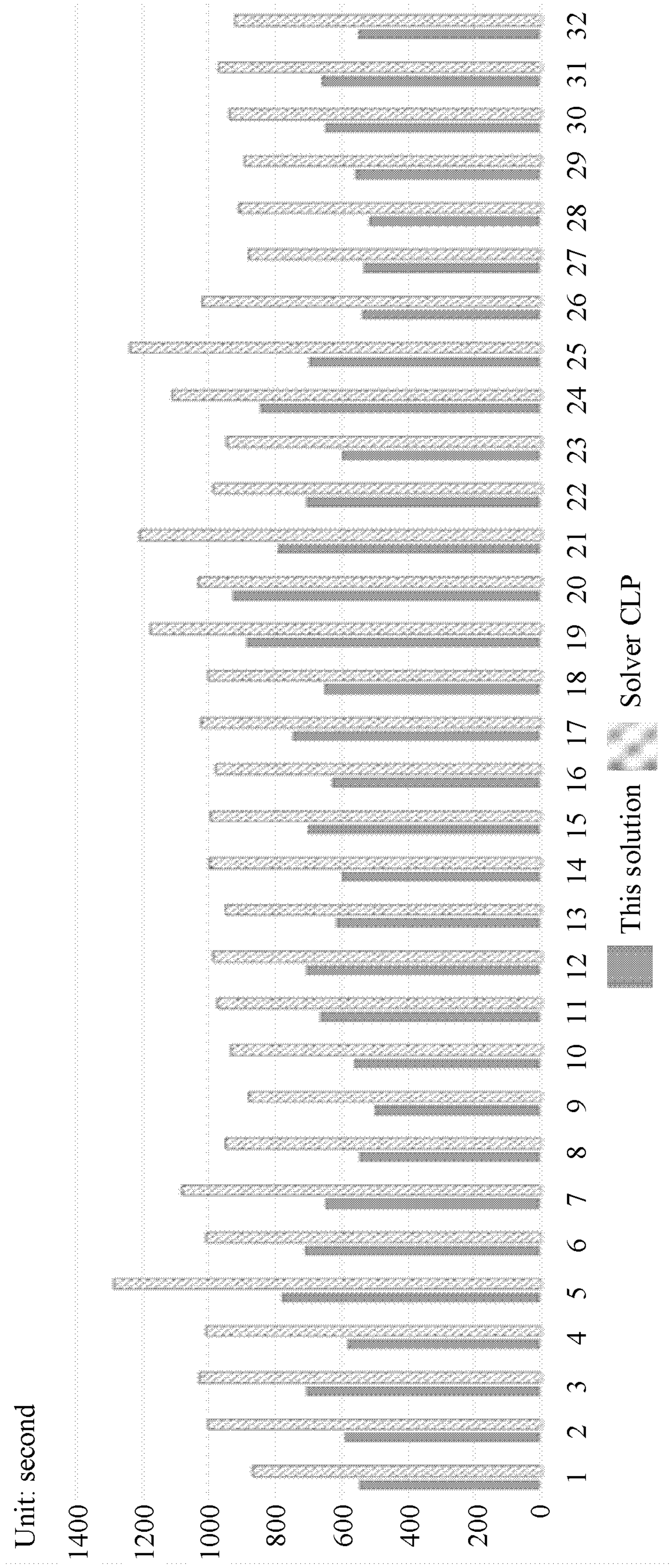
Unit: second
1400
1200
1000
800
600
400
200
0
1
2
3
4
5
6
7
8
9
10
11
12
13
14
15
16
17
18
19
20
21
22
23
24
25
26
27
28
29
30
31
32
This solution
Solver CLP

FIG. 10

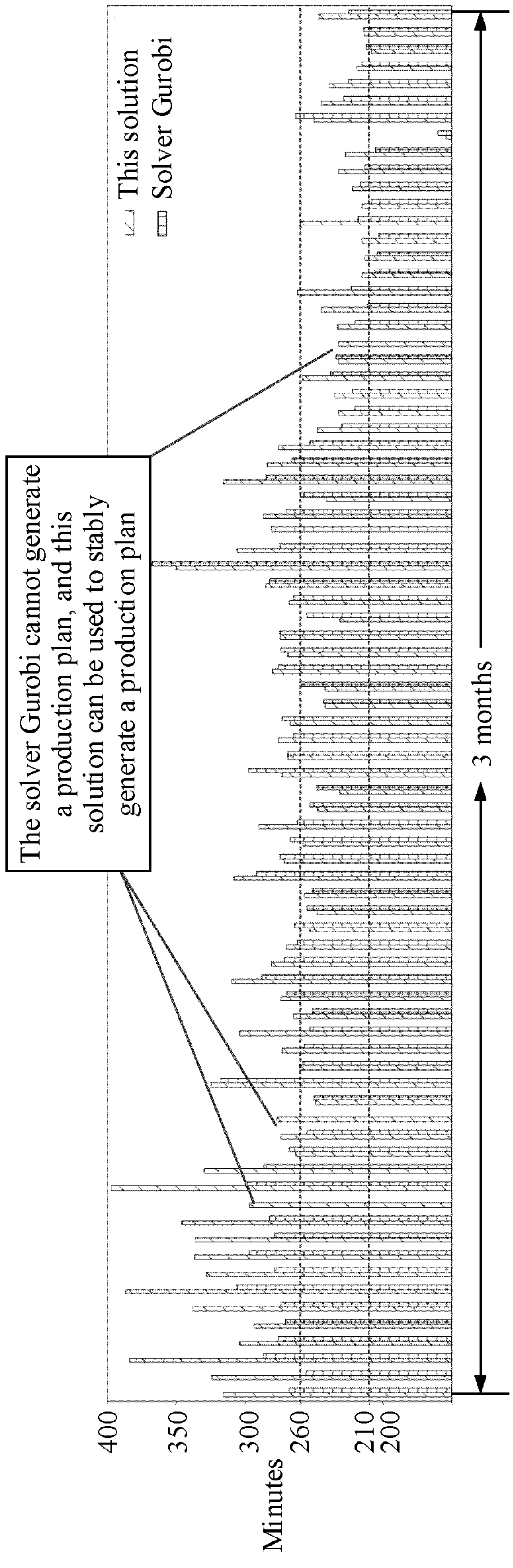
The solver Gurobi cannot generate a production plan, and this solution can be used to stably generate a production plan
This solution
Solver Gurobi
3 months
Minutes
400
350
300
260
210
200

FIG. 11

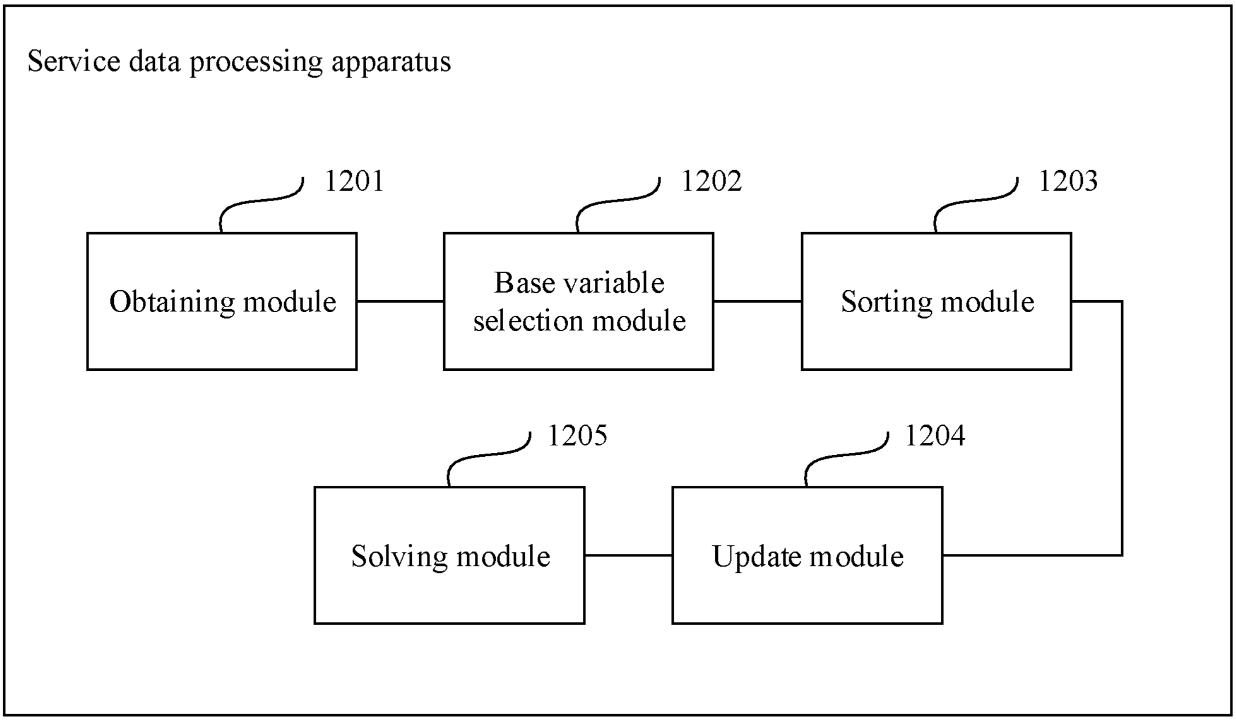
Service data processing apparatus
1201
1202
1203
Obtaining module
Base variable selection module
Sorting module
1205
1204
Solving module
Update module

FIG. 12

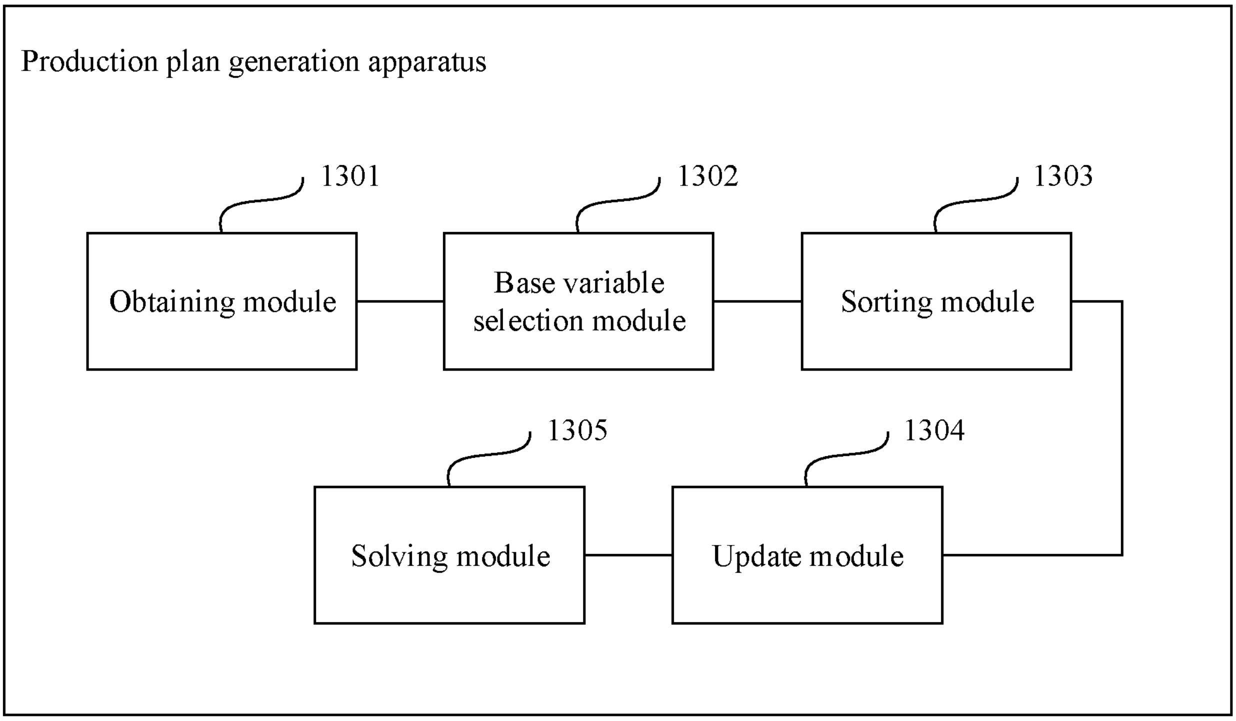
Production plan generation apparatus
1301
1302
1303
Obtaining module
Base variable selection module
Sorting module
1305
1304
Solving module
Update module

FIG. 13

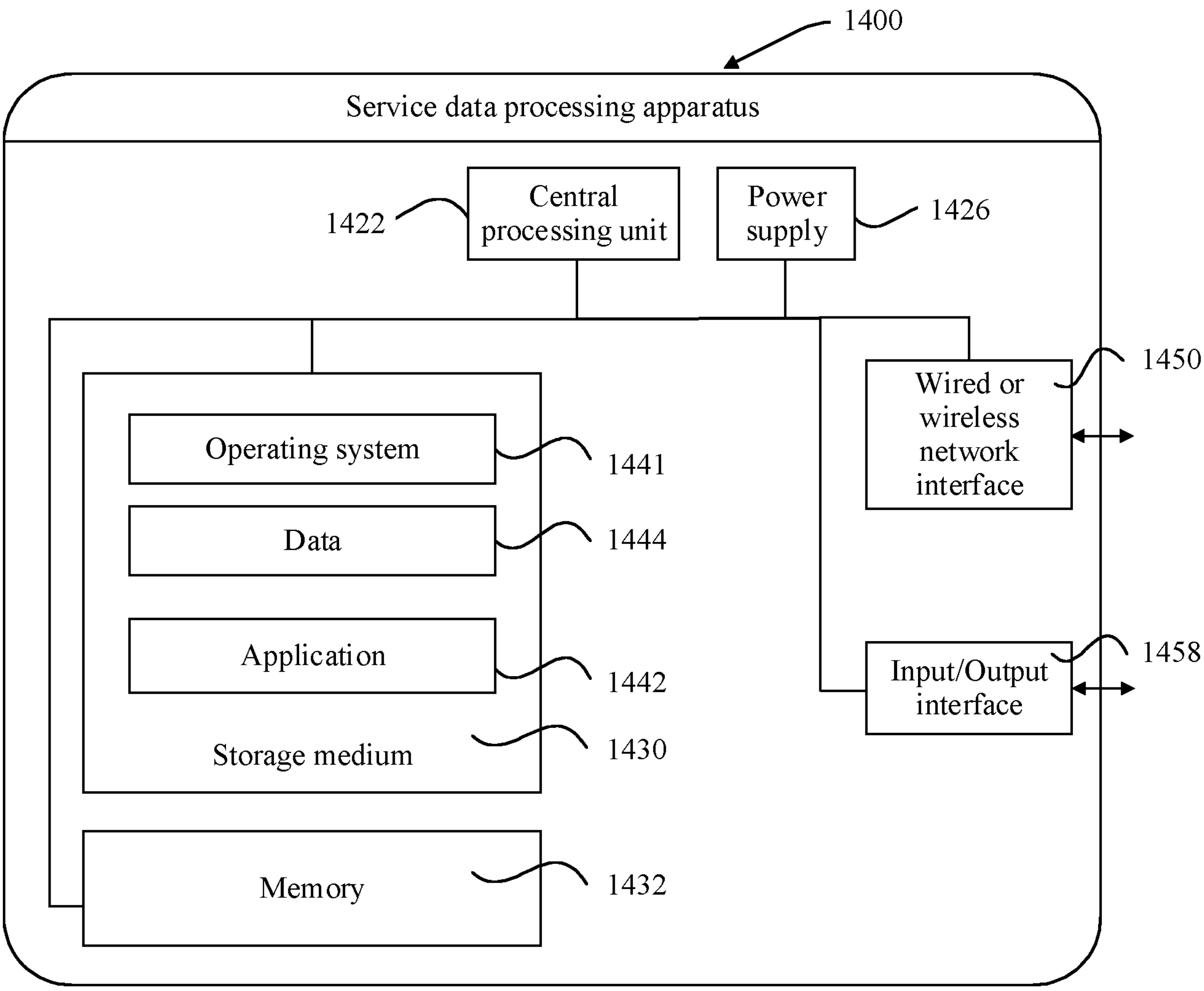
1400
Service data processing apparatus
1422
Central processing unit
Power supply
1426
1450
Wired or wireless network interface
Operating system
1441
Data
1444
Application
1442
Storage medium
1430
1458
Input/Output interface
Memory
1432

FIG. 14

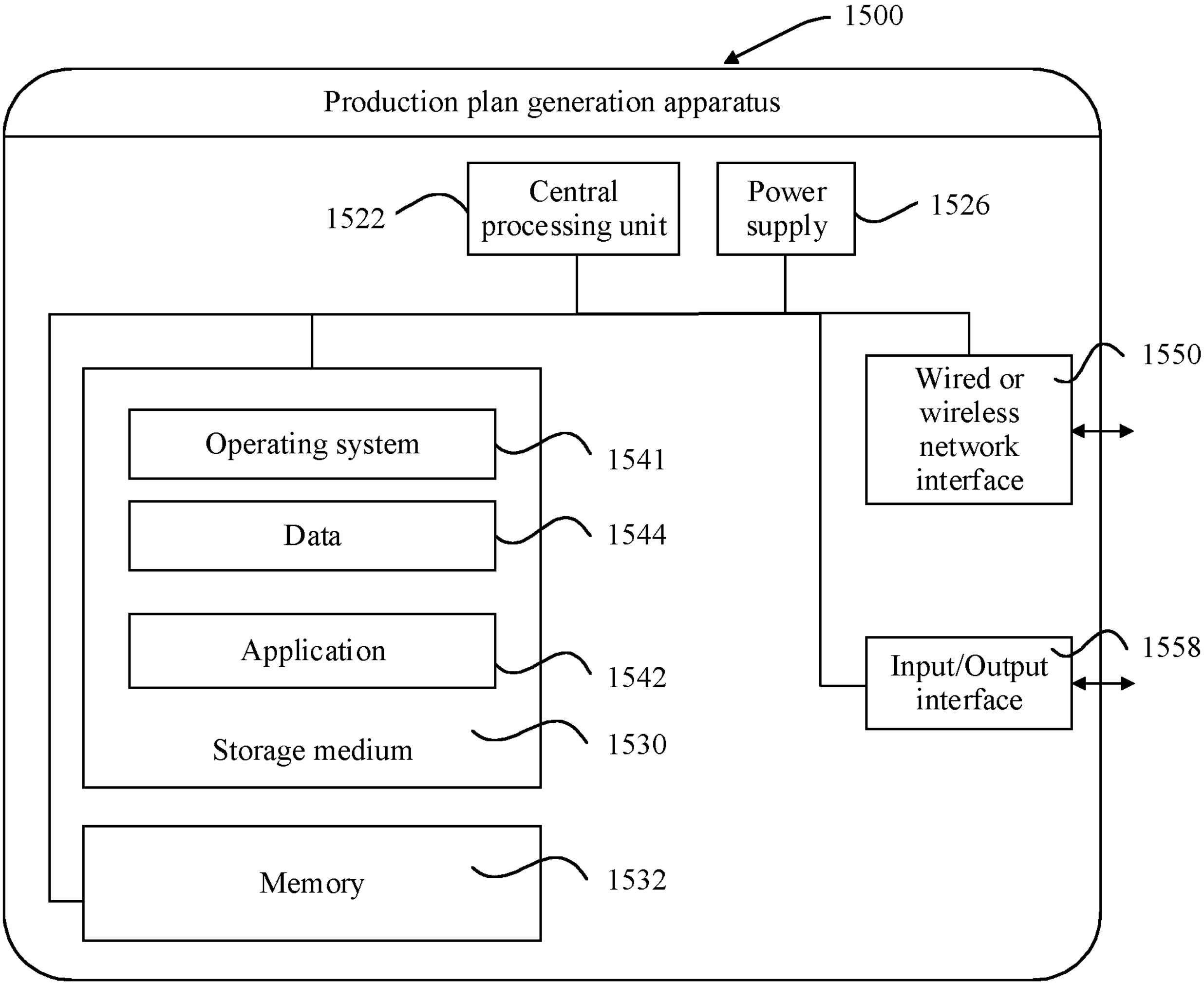
1500
Production plan generation apparatus
1522
Central processing unit
Power supply
1526
1550
Wired or wireless network interface
Operating system
1541
Data
1544
Application
1542
Storage medium
1530
Input/Output interface
1558
Memory
1532

FIG. 15

## INTERNATIONAL SEARCH REPORT

International application No.
**PCT/CN2022/093732**

### A. CLASSIFICATION OF SUBJECT MATTER

G06Q 10/04(2012.01)i

According to International Patent Classification (IPC) or to both national classification and IPC

### B. FIELDS SEARCHED

Minimum documentation searched (classification system followed by classification symbols)

G06Q

Documentation searched other than minimum documentation to the extent that such documents are included in the fields searched

Electronic data base consulted during the international search (name of data base and, where practicable, search terms used)

CNPAT, CNKI, WPI, EPODOC, IEEE: 业务, 目标函数, 约束条件, 求解, 基变量, 非基变量, 初始, 优化, 排序, 堆结构, 节点, 优化速率, 更新, 生产计划, business, objective function, constraint condition, solve, base variables, non-base variables, initial, optimization, rank, heap structure, node, optimization rate, update, production plan

### C. DOCUMENTS CONSIDERED TO BE RELEVANT

| Category* | Citation of document, with indication, where appropriate, of the relevant passages | Relevant to claim No. |
|---|---|---|
| A | CN 111309472 A (ONGINEER IT CO., LTD.) 19 June 2020 (2020-06-19)<br>description, paragraphs [0085]-[0113] | 1-35 |
| A | CN 105554771 A (CHONGQING UNIVERSITY OF POSTS AND TELECOMMUNICATIONS) 04 May 2016 (2016-05-04)<br>entire document | 1-35 |
| A | CN 111860944 A (CHINA ELECTRIC POWER RESEARCH INSTITUTE CO., LTD. et al.) 30 October 2020 (2020-10-30)<br>entire document | 1-35 |
| A | CN 104486641 A (TSINGHUA UNIVERSITY et al.) 01 April 2015 (2015-04-01)<br>entire document | 1-35 |
| A | US 6208915 B1 (DAIMLERCHRYSLER AG.) 27 March 2001 (2001-03-27)<br>entire document | 1-35 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 July 2022** | **28 July 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.
**PCT/CN2022/093732**

| Patent document cited in search report | | | Publication date (day/month/year) | Patent family member(s) | | | Publication date (day/month/year) |
|---|---|---|---|---|---|---|---|
| CN | 111309472 | A | 19 June 2020 | None | | | |
| CN | 105554771 | A | 04 May 2016 | None | | | |
| CN | 111860944 | A | 30 October 2020 | None | | | |
| CN | 104486641 | A | 01 April 2015 | None | | | |
| US | 6208915 | B1 | 27 March 2001 | EP | 0977687 | A1 | 09 February 2000 |
| | | | | DE | 19718922 | C1 | 02 April 1998 |
| | | | | WO | 9849058 | A1 | 05 November 1998 |
| | | | | JP | 2002505632 | A | 19 February 2002 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202110680969